# EUROPÄISCHE PATENTSCHRIFT

(11) **EP 2 126 992 B1**
(45) Veröffentlichungstag und Bekanntmachung des Hinweises auf die Patenterteilung: **04.03.2015**
(21) Anmeldenummer: 08701584.8
(22) Anmeldetag: 18.01.2008
(51) Int. Cl.: H01L 41/083, H01L 41/09, H04R 17/02

(54) **PIEZOELEKTRISCHES BAUELEMENT**
PIEZOELECTRIC COMPONENT
COMPOSANT PIÉZOÉLECTRIQUE

(30) Priorität: 23.01.2007 DE 102007003280
(43) Veröffentlichungstag der Anmeldung: 02.12.2009
(73) Patentinhaber: Epcos AG, 81669 München (DE)
(72) Erfinder: ENGEL, Günter, 8430 Leibnitz (AT)
(74) Vertreter: Epping - Hermann - Fischer
(86) Internationale Anmeldenummer: PCT/EP2008/050578
(87) Internationale Veröffentlichungsnummer: WO 2008/090095

(56) Entgegenhaltungen:
- EP-A2- 0 993 055
- WO-A1-92/06511
- DE-A1- 3 142 684
- JP-A- 1 261 879
- US-A- 5 860 202
- US-A1- 2003 133 230

## Beschreibung

Ein piezoelektrisches Bauelement ist beispielsweise aus der Druckschrift US 6,346,764 B1 bekannt. Die Druckschrift US 2003/0133230 A zeigt ein piezoelektrisches Bauelement mit vier aktiven Bereichen, in denen eine gemeinsame Elektrodenschicht und jeweils eine davon separate Elektrodenschicht angeordnet ist. Ein jeweiliger zentraler Bereich zwischen jeweils zwei aktiven Bereichen sowie zwei Endbereiche bilden inaktive Bereiche des Bauelements. In den Druckschriften JP 01-261879 A, DE 3142684 A1 und EP 0993055 A2 sind piezoelektrische Bauelemente mit einem Schichtstapel gezeigt, in dem zwischen piezoelektrischen Schichten Elektrodenschichten angeordnet sind. Gemäß der Druckschrift JP 01-261879 A nimmt die Dicke der piezoelektrischen Schichten mit zunehmendem Abstand von einer dünnen Platte, auf der der Schichtstapel angeordnet ist, ab. Gemäß der Druckschrift DE 3142684 A1 nimmt die Dicke der piezoelektrischen Schichten von der Mitte des Stapels nach außen hin ab. Gemäß der Druckschrift EP 0993055 A2 nimmt die Dicke der piezoelektrischen Schichten ausgehend vom Zentrum des Schichtstapels in Richtung zur Oberseite des Stapels beziehungsweise in Richtung zur Unterseite des Stapels ab.

Eine zu lösende Aufgabe besteht darin, ein piezoelektrisches Bauelement sowie eine schwingfähige Bauelementanordnung mit einem piezoelektrischen Bauelement anzugeben, die sich jeweils durch einen hohen Wirkungsgrad auszeichnen.

Die Aufgabe in Bezug auf das piezoelektrische Bauelement wird mit der im Patentanspruch 1 angegebenen Ausführungsform eines piezoelektrischen Bauelements gelöst.

Gemäß einer Ausführungsform umfasst das piezoelektrische Bauelement einen Körper mit piezoelektrischen Eigenschaften. Der Körper umfasst abwechselnd übereinander angeordnete piezoelektrische Schichten und Elektrodenebenen mit darin angeordneten ersten, zweiten und dritten Elektroden.

Im Körper sind elektrisch und mechanisch miteinander verbundene Wandlerelemente realisiert, die durch einen im Wesentlichen feldfreien und daher stressfreien neutralen Bereich des Körpers voneinander beabstandet sind. Ein erstes Wandlerelement weist leitend miteinander verbundene erste Elektroden auf. Ein zweites Wandlerelement weist leitend miteinander verbundene zweite Elektroden auf. Im Körper ist mindestens eine dritte Elektrode angeordnet, die sowohl im ersten als auch im zweiten Wandlerelement angeordnet ist. Mindestens drei Elektroden, ausgewählt aus den ersten und dritten Elektroden, sind in einer alternierenden Reihenfolge angeordnet. Mindestens drei Elektroden, ausgewählt aus den zweiten und dritten Elektroden, sind in einer alternierenden Reihenfolge übereinander angeordnet. Der neutrale Bereich ist senkrecht zu Lateralebenen ausgerichtet, in denen die Elektroden angeordnet sind.

Im Körper können auch mehr als nur zwei Wandlerelemente integriert sein, wobei mindestens zwei der Wandlerelemente oder alle Wandlerelemente vorzugsweise elektrisch miteinander verbunden sind. Das jeweilige Wandlerelement ist in einem Serienzweig oder Querzweig einer dabei gebildeten elektrischen Schaltung angeordnet.

Das piezoelektrische Bauelement ist zur Wandlung einer elektrischen Energie in die mechanische Energie oder umgekehrt vorgesehen. Das piezoelektrische Bauelement kann als ein Aktor (auf Englisch actuator) zur Anregung mechanischer Schwingungen einer schwingfähigen Membran benutzt werden. Das piezoelektrische Bauelement kann auch als ein Sensorelement benutzt werden, das zur Umsetzung einer mechanischen Deformation, insbesondere der akustischen Schwingung einer Membran, in ein elektrisches Signal vorgesehen ist. Das piezoelektrische Bauelement kann beispielsweise als ein Mikrofonelement in einer Mikrofonanordnung eingesetzt werden.

Das piezoelektrische Bauelement dient in einer weiteren vorteilhaften Variante zur Anregung von Schwingungen einer Lautsprechermembran, mit der es zur Bildung einer Bauelementanordnung bzw. einer Lautsprecheranordnung fest verbunden ist. Nachstehend wird die Bauelementanordnung ohne Einschränkung auf die Lautsprecheranwendung oder auf den Einsatz des piezoelektrischen Bauelements als ein Aktor am Beispiel einer Lautsprecheranordnung erläutert.

Das piezoelektrische Bauelement ist vorzugsweise als ein Platten- oder Biegeschwinger mit einer großen piezoelektrischen Kopplung ausgelegt.

Das piezoelektrische Bauelement zeichnet sich durch eine hohe Energiedichte aus, die auf einem vergleichsweise kleinen Raum konzentriert ist. Die Kapazitätsverteilung im piezoelektrischen Bauelement ist für den aufgenommenen Strom und Verluste maßgeblich, da die Blindleistung mit steigender Kapazität ansteigt. Durch die Aufteilung einer im Körper integrierten elektromechanischen Funktionseinheit in zwei Wandlerelemente kann eine besonders kleine Kapazität des piezoelektrischen Bauelements und daher eine hohe piezoelektrische Wirkung bei geringem Stromverbrauch erzielt werden. Umgekehrt gilt es für Sensoranwendungen, wobei das piezoelektrische Bauelement Strom in eine elektrische Schaltung liefern soll, dass durch die geringe Kapazität des piezoelektrischen Bauelements eine hohe Energiedichte eines Nutzsignals erzielt werden kann.

Durch die entsprechende Ausgestaltung der Wandlerelemente, darunter durch eine geeignete Wahl des Materials, der Anzahl und Schichtstärke piezoelektrischer Schichten und der lateralen Dimensionen von Wandlerelementen, kann die in der Lautsprecheranordnung umzusetzende Energie bevorzugt dort gewandelt werden, wo die Anregung mechanischer Schwingungen erwünscht ist. Für piezoelektrische Schichten kommen PZT-Keramiken mit beliebiger Rezeptur oder auch andere geeignete piezoelektrische Keramiken mit geringem Verlustwinkel in Betracht.

Weitere Verbesserungen können durch die Art der Außenkontaktierung des piezoelektrischen Bauelements erzielt werden. Die Außenkontakte können z. B. durch Auftragen und anschließendes Einbrennen einer silberhaltigen Metallpaste oder durch Aufsputtern einer Metallschicht erzeugt werden. Die Außenkontakte können mehrere Schichten aus unterschiedlichen Materialien aufweisen.

Die Wandlerelemente sind jeweils durch eine Steuerspannung ansteuerbar. Die Steuerspannung enthält ein Nutzsignal, das vorzugsweise mit einer Gleichspannung überlagert ist. Durch das Anlegen der Gleichspannung, also durch die Vorspannung des jeweiligen Wandlerelements gelingt die Voreinstellung einer Lautstärke. Die Gleichspannung ist in einer vorteilhaften Variante frequenzabhängig. Die Gleichspannung kann mit der Frequenz steigen oder abfallen. Insbesondere ist es möglich, ein Wandlerelement mit einer mit der Frequenz steigenden Gleichspannung und das andere Wandlerelement mit einer mit der Frequenz abfallenden Gleichspannung vorzuspannen.

Bei einer geeigneten Vorspannung der Wandlerelemente kann eine frequenzabhängige Signalumsetzung in Membranschwingungen erzielt werden.

Die akustischen Schwingungen einer Lautsprechermembran werden durch das an sie angekoppelte piezoelektrische Bauelement angeregt. Die Lautsprecheranordnung hat in der Regel eine natürliche Eigenschwingung im Bereich von 600 Hz bis 1 kHz. Vorzugsweise wird zusätzlich eine weitere Eigenschwingung der Lautsprecheranordnung piezoelektrisch angeregt, deren Resonanzfrequenz größer als die Frequenz der ersten Eigenschwingung ist. Die Frequenz der zweiten Eigenschwingung liegt vorzugsweise oberhalb von 5 kHz, vorzugsweise im Bereich von 6 kHz - z. B. zwischen 5,5 kHz und 6,5 kHz - oder oberhalb von 6 kHz.

Der neutrale Bereich ist zwischen den Wandlerelementen angeordnet. Die Wandlerelemente sind somit nebeneinander, aber im Abstand voneinander angeordnet und durch die Einführung des spannungs- und deformationsfreien neutralen Bereichs im Wesentlichen mechanisch voneinander entkoppelt. Die nebeneinander angeordneten Wandlerelemente weisen vorzugsweise im Wesentlichen den gleichen oder zueinander symmetrischen Aufbau und insbesondere im Wesentlichen den gleichen Kapazitätswert auf.

In einer vorteilhaften Variante sind mindestens zwei galvanisch voneinander getrennte Elektroden unterschiedlicher Wandlerelemente in einer Elektrodenebene angeordnet. Die ersten Elektroden und zweiten Elektroden sind jeweils von außen kontaktierbar. Die dritten Elektroden können, müssen aber nicht von außen kontaktierbar sein.

Durch eine geeignete Dimensionierung der dritten Elektroden und der piezoelektrischen Schichten können insbesondere die Kapazität und/oder der Verlustwinkel verringert werden. Vorzugsweise wird eine sehr kleine Kapazität und ein sehr kleiner Verlustwinkel bei relativ großer Fläche der Elektroden und dünner Schichtstärke eingestellt. Die Kapazität des jeweiligen Wandlerelements beträgt dabei vorzugsweise maximal 2 µF.

Die piezoelektrischen Schichten enthalten in einer vorteilhaften Variante Keramik mit piezoelektrischen Eigenschaften. Zur Anregung von Lateralschwingungen mit dem piezoelektrischen Koeffizient d₁₃ sowie zur Erzielung eines flachen Frequenzganges der schwingfähigen Bauelementanordnung sind gepolte ferroelektrische Keramiken wie z. B. Blei-Zirkonat-Titanat besonders gut geeignet.

Die Schichtstärke jeder einzelnen piezoelektrischen Schicht kann im angegebenen piezoelektrischen Bauelement besonders klein gewählt werden. Dies erhöht bei gleich bleibender Steuerspannung die Feldstärke in der jeweiligen Schicht, womit besonders hohe Auslenkungen ermöglicht werden.

Der Körper ist in einer vorteilhaften Variante bezüglich einer Ebene, in der der Mittelpunkt des Körpers liegt und die senkrecht zu den Schichten des Körpers ausgerichtet ist, spiegelsymmetrisch ausgebildet.

Die Aufgabe in Bezug auf die Bauelementanordnung wird mit der im Patentanspruch 6 angegebenen Bauelementanordnung gelöst.

Gemäß einer möglichen Ausführungsform umfasst die Bauelementanordnung eine Membran und ein fest mit dieser verbundenes piezoelektrisches Bauelement. Das piezoelektrische Bauelement ist zur Anregung von mindestens zwei Schwingungsmoden der Bauelementanordnung vorgesehen. Das piezoelektrische Bauelement weist mindestens zwei in einem Körper realisierte Wandlerelemente auf, zwischen denen ein neutraler Bereich angeordnet ist.

Durch die feste Verbindung zwischen der Membran und dem Körper des piezoelektrischen Bauelements kann sich der Körper in einem unmittelbar an die Membran angrenzenden Bereich nicht ausdehnen. Ein von der Membran abgewandter Bereich des Körpers ist dagegen ausdehnungsfähig in Lateralrichtung. Dadurch werden Biegedeformationen der Bauelementanordnung erzwungen.

Der zur Membran gewandte, an der Membran befestigte Bereich des jeweiligen Wandlerelements bildet also einen lateralen Einspannungsbereich des Wandlerelements. Da der zwischen den Wandlerelementen angeordnete neutrale Bereich im Wesentlichen stressfrei ist, wirkt er so, als ob das jeweilige Wandlerelement an seinem an den neutralen Bereich angrenzenden Bereich eingespannt wäre. Der neutrale Bereich bildet daher einen vertikalen Einspannungsbereich für das jeweilige Wandlerelement.

In Einspannungsbereichen und in ihrer Nähe findet praktisch keine Auslenkung des jeweiligen Wandlerelements in Lateralrichtung statt. Dies führt dazu, dass am gegenüber liegenden freien Ende des Wandlerelements eine um so größere laterale Auslenkung erfolgt. Durch die Einführung des neutralen Bereichs gelingt es also, die Biegedeformation des Körpers bzw. der Bauelementanordnung zu verstärken.

Gemäß einer weiteren Ausführungsform der Bauelementanordnung ist eine Hauptfläche des Körpers an der Membran befestigt.

Die Wandlerelemente sind vorzugsweise nebeneinander angeordnet und in einer vorteilhaften Variante durch einen im Wesentlichen stressfreien neutralen Bereich voneinander entkoppelt.

Die Wandlerelemente sind vorzugsweise unabhängig voneinander ansteuerbar. Die Ansteuerung von zwei Wandlerelementen durch zwei unabhängige Steuersignale kann insbesondere zum Ausgleich des Frequenzgangs des durch die Bauelementanordnung erzeugten Schalldrucks verwendet werden, beispielsweise indem mindestens zwei Schwingungsmoden angeregt werden oder die Resonanz einer Mode durch Verringerung der Güte der Bauelementänordnung absichtlich verflacht wird. Unter der Güte der Bauelementanordnung versteht man das Verhältnis der Resonanzfrequenz, bei der die maximale Schwingamplitude der Membran erzielt wird, zur Differenz der Frequenzen, bei denen ein bestimmter Pegel der Schwingamplitude wie z. B. 3 dB erzielt wird.

Durch die unabhängige Ansteuerung von Wandlerelementen kann mit nur einem piezoelektrischen Bauelement ein Stereosignal in Membranschwingungen umgesetzt werden.

Gemäß einer weiteren Ausführungsform wird das piezoelektrische Bauelement durch eine frequenzabhängige Steuerspannung angesteuert. Das Bauelement weist einen Körper auf, in dem mindestens zwei Wandlerelemente realisiert sind, die jeweils durch mindestens eine frequenzabhängige Steuerspannung angesteuert werden.

Gemäß einer Ausführungsform weist die Bauelementanordnung mindestens zwei übereinander angeordnete Wandlerelemente auf, die voneinander unterschiedliche Schichtstärken piezoelektrischer Schichten, d. h. voneinander unterschiedliche Abstände zwischen unterschiedlich gepolten Elektroden, aufweisen. Die Wandlerelemente sind vorzugsweise elektrisch miteinander verbunden.

Die übereinander angeordneten Wandlerelemente können eine voneinander unterschiedliche Anzahl von piezoelektrischen Schichten und Elektroden aufweisen.

In einer vorteilhaften Variante ist eine Brückenschaltung von vier Wandlerelementen möglich. Dabei sind vorzugsweise jeweils zwei Wandlerelemente übereinander und zwei Wandlerelemente nebeneinander angeordnet.

Der Körper weist mindestens zwei nebeneinander angeordnete Lateralbereiche auf, die durch den neutralen Bereich voneinander entkoppelt sind. In jedem Lateralbereich ist eines der Wandlerelemente angeordnet.

Die übereinander oder nebeneinander angeordneten Wandlerelemente sind in einer Variante separat voneinander ansteuerbar. Vorzugsweise werden die unteren Wandlerelemente mit einem gemeinsamen ersten Steuersignal und die oberen Wandlerelemente mit einem zweiten Steuersignal angesteuert. Mit der separaten Ansteuerung unterschiedlicher Lateralbereiche des Körpers gelingt es, die piezoelektrische Wirkung im piezoelektrischen Bauelement und somit auch den Frequenzgang der Bauelementanordnung zu beeinflussen.

Zwischen zwei übereinander angeordneten Wandlerelementen kann im Prinzip ein im Wesentlichen feldfreier Bereich vorgesehen sein, der sich in einer Lateralrichtung erstreckt.

Durch die Übereinanderstapelung unterschiedlicher Wandlerelemente gelingt es, die Verschiebung der Resonanzfrequenzen der Bauelementanordnung zu erzielen sowie mehr als nur eine Schwingungsmode anzuregen.

Die vorteilhaften Ausführungsformen des piezoelektrischen Bauelements und der Bauelementanordnung mit piezoelektrischem Bauelement können beliebig miteinander kombiniert werden.

Für alle Ausführungsformen der Bauelementanordnung gilt, dass die höherfrequente der mithilfe des piezoelektrischen Bauelements anzuregenden Schwingungsmoden vorzugsweise oberhalb von 5 kHz eingestellt ist. In einer vorteilhaften Variante überlappen die Resonanzkurven der mindestens zwei Schwingungsmoden derart, dass der Frequenzgang der Bauelementanordnung im vorgegebenen Nutzbereich den Leistungseinbruch von nicht mehr als 3 dB bezogen auf die maximale Schwingungsamplitude der Bauelementanordnung aufweist. Dies kann insbesondere dadurch bewerkstelligt werden, dass in einem Körper zwei oder mehr Wandlerelemente realisiert sind, sowie durch nachstehend erläuterte Varianten der Ansteuerung der Wandlerelemente.

Im Folgenden werden Eigenschaften und Aufbau des angegebenen Bauelements sowie seine vorteilhaften Ausführungsformen näher erläutert.

Der Körper ist vorzugsweise als eine Platte ausgebildet, in der durch ein elektrisches Signal insbesondere Lateralauslenkungen mit einem piezoelektrischen Koeffizienten d₁₃ hervorgerufen werden.

Die kleinste laterale Dimension der Platte, d. h. ihre Breite, übersteigt die Dicke vorzugsweise mindestens um einen Faktor fünf. Die Dicke der Platte beträgt in einer vorteilhaften Variante maximal 10%, in einer Variante maximal 5% der lateralen Breite der Platte.

Die lateralen Dimensionen, d. h. die Länge und Breite, der Platte sind in einer Variante zwischen 10 und 40 mm gewählt. Die Dicke der Platte beträgt vorzugsweise maximal 200 Mikrometer. Die Plattendimension beträgt in einer Variante 15 mm x 20 mm x 120 µm.

Die Platte weist vorzugsweise zwischen 4 und 20 piezoelektrische Schichten auf. Die Schichtdicke ist vorzugsweise zwischen 10 und 50 Mikrometer.

Die Platte kann rechteckig oder in Form einer Scheibe ausgebildet sein. Die Form der Platte ist vorzugsweise an diejenige der Membran angepasst. Beispielsweise ist es vorteilhaft, eine rechteckige Platte an eine rechteckige Membran oder eine scheibenförmige Platte an eine runde Membran anzukoppeln.

Die Elektroden und die piezoelektrischen Schichten sind vorzugsweise parallel zur Hauptfläche des Körpers ausgerichtet. Vorzugsweise ist die jeweilige dritte Elektrode zwischen zwei ersten Elektroden und zwischen zwei zweiten Elektroden angeordnet. In einer bevorzugten Variante sind mehrere dritte Elektroden vorgesehen. Vorzugsweise ist mindestens eine der ersten Elektroden und mindestens eine der zweiten Elektroden zwischen zwei dritten Elektroden angeordnet.

Die galvanisch miteinander zu verbindenden Elektroden des jeweiligen Wandlerelements sind vorzugsweise durch eine als Sammelelektrode und Außenanschluss des piezoelektrischen Bauelements vorgesehene, an der Seitenfläche des Körpers angeordnete leitende Fläche miteinander verbunden. Die Elektroden sind von der Oberfläche des Körpers vorzugsweise zurückgezogen bis auf Anschlussbereiche, in denen die Elektrode an den jeweiligen Außenanschluss angeschlossen ist.

Die dritten Elektroden sind von den ersten und von den zweiten Elektroden galvanisch getrennt. Die ersten und zweiten Elektroden können galvanisch voneinander getrennt und an jeweils einen eigenen Außenanschluss des Bauelements angeschlossen sein. Die ersten und zweiten Elektroden können aber auch mit einem gemeinsamen Außenanschluss des Bauelements leitend verbunden sein, beispielsweise wenn es vorgesehen ist, eine Parallelschaltung der Wandlerelemente durch ein gemeinsames Steuersignal anzusteuern.

Die dritten Elektroden sind in einer Variante als Blindelektroden ausgebildet. Unter einer Blindelektrode versteht man eine Elektrode, die nicht zu einer elektrischen Verschaltung mit einem definierten elektrischen Potential vorgesehen ist, auch wenn die Blindelektroden an einen Außenanschluss angeschlossen sein können, um die Blindelektroden z. B. bei der Erzeugung einer Vorpolarisation in den piezoelektrischen Schichten kontaktieren zu können.

Die dritten Elektroden sind in einer Variante elektrisch voneinander isoliert und als floatende Elektroden ausgebildet. Die floatenden Elektroden sind in einer Variante galvanisch voneinander sowie von anderen Elektroden der Wandlerelemente getrennt.

Die dritten Elektroden können aber auch leitend miteinander verbunden sein. Sie können dabei an einen Außenanschluss des piezoelektrischen Bauelements angeschlossen sein, der an der Oberfläche des Körpers angeordnet ist.

Die Wandlerelemente werden mit mindestens einem Steuersignal angesteuert. Das jeweilige Wandlerelement wird mit einem Steuersignal angesteuert, das einen Wechselspannungsanteil aufweist.

In einer vorteilhaften Variante werden die Wandlerelemente durch Anlegen einer elektrischen Gleichspannung vorgespannt. Mit der Gleichspannung wird ein vorgegebener Arbeitspunkt des piezoelektrischen Bauelements festgelegt. Je nach Höhe der Gleichspannung kann ein gewünschter Betrag des Elastizitätsmoduls der piezoelektrischen Schichten und somit ein bestimmter dynamischer Bereich der Bauelementanordnung eingestellt werden. Dieser Wert wird dann durch ein Nutzsignal moduliert. Das Nutzsignal stellt eine Wechselspannung dar, mit der eine akustische Schwingung der Bauelementanordnung angeregt wird. Ein akustisches Nutzsignal wird beispielsweise durch einen Audiochip, der ein Verstärkerelement aufweist, erzeugt.

Durch die Änderung des Elastizitätsmoduls des piezoelektrischen Bauelements ist es möglich, die Resonanzfrequenz der Lautsprecheranordnung, also die Eigenfrequenz der jeweiligen Schwingungsmode, zu beeinflussen und insbesondere zu erhöhen. Die elastische Konstante steigt quadratisch mit der elektrischen Feldstärke an. Daher besteht die Möglichkeit, durch die elektrische Vorspannung des piezoelektrischen Bauelements die elastische Konstante, oder das Elastizitätsmodul, des piezoelektrischen Materials zu steuern, insbesondere zu erhöhen.

Insbesondere gelingt es, die Schwingungsmode mit der höheren Eigenfrequenz zu beeinflussen. Die Resonanzfrequenz der höheren Mode kann gezielt zu einer höheren Frequenz verschoben werden, die oberhalb des vorgegebenen Nutzbereichs der Lautsprecheranordnung liegt. Die Frequenz der Schwingungsmode mit der niedrigeren Eigenfrequenz kann aber auch verschoben, insbesondere erhöht, werden.

Durch die Veränderung des E-Moduls des piezoelektrischen Materials in einem Wandlerelement des piezoelektrischen Bauelements kann beispielsweise die Feineinstellung der Resonanzfrequenz um einige Prozent bewerkstelligt werden. Insbesondere kann durch das Anlegen einer mit einem akustischen Nutzsignal überlagerten DC-Steuerspannung die Resonanzfrequenz erhöht werden.

Das Nutzsignal wird in einer vorteilhaften Variante zur Bildung eines Steuersignals mit dem Gleichspannungssignal überlagert. Die Amplitude der Gleichspannung ist vorzugsweise größer als diejenige des Nutzsignals gewählt.

Das Steuersignal setzt sich also aus einem Nutzsignal mit AC-Anteil und einem Gleichspannungssignal positiver oder negativer Polarität zusammen. Das positive oder negative elektrische Potential und das Nutzsignal können an dieselben Elektroden des jeweiligen Wandlerelements angelegt werden. Das Gleichspannungsanteil und das Nutzsignal können aber auch an unterschiedliche Elektroden des Wandlerelements angelegt werden.

Verschiedene Wandlerelemente des piezoelektrischen Bauelements können durch ein gemeinsames Steuersignal angesteuert werden.

Mindestens zwei der leitend miteinander verbundenen, in einem gemeinsamen Körper realisierten Wandlerelemente können beispielsweise in Serie geschaltet sein. Bei der Ansteuerung wird das Steuersignal vorzugsweise an die Serienschaltung der Wandlerelemente angelegt.

Mindestens zwei der Wandlerelemente können alternativ parallel geschaltet sein, wobei das Steuersignal an die Parallelschaltung der Wandlerelemente angelegt wird. In einer Variante wird ein Steuersignal an die ersten und zweiten Elektroden des piezoelektrischen Bauelements angelegt und die mindestens eine dritte Elektrode an ein Bezugspotential angeschlossen.

In einer Variante erfolgt die Ansteuerung der Wandlerelemente über ihre gemeinsamen Elektroden. Das Steuersignal wird dabei an die mindestens eine dritte Elektrode angelegt. Die ersten Elektroden sind dann vorzugsweise an ein ersten Bezugspotential und die zweiten Elektroden an ein zweites Bezugspotential angeschlossen. Die ersten und zweiten Elektroden können auch an ein gemeinsames Bezugspotential angeschlossen sein.

Das jeweilige Bezugspotential kann ein Null-Potential bzw. Masse sein. Das Bezugspotential kann durch eine DC-Spannung positiver oder negativer Polarität ersetzt werden. In einer Variante ist die mindestens eine dritte Elektrode zur Einspeisung einer DC-Steuerspannung mit einer positiven oder negativen Polarität vorgesehen. In einer weiteren Variante sind die ersten und/oder zweiten Elektroden zur Einspeisung der DC-Steuerspannung vorgesehen.

Die Wandlerelemente können gemäß einer weiteren Variante unabhängig voneinander, d. h. durch voneinander unterschiedliche Steuersignale, angesteuert werden. An die ersten Elektroden wird beispielsweise ein erstes Steuersignal und an die zweiten Elektroden ein zweites Steuersignal angelegt. Die dritten Elektroden sind dabei vorzugsweise mit einem Bezugspotential verbunden.

Die Wandlerelemente, insbesondere nebeneinander angeordnete Wandlerelemente, können sowohl bei der Ansteuerung mit nur einem Steuersignal als auch bei der Ansteuerung mit mehreren Steuersignalen mit einem gemeinsamen Bezugspotential oder voneinander unterschiedlichen Bezugspotentialen verbunden sein.

Es bestehen verschiedene Möglichkeiten zur Einstellung eines vergleichsweise hohen Wirkungsgrades für eine effiziente Umsetzung der elektrischen Energie in die mechanische oder umgekehrt.

Eine möglichst starre Verbindung zwischen dem Körper des piezoelektrischen Bauelements und der Membran ist zu einer effizienten Umsetzung der elektrischen Energie des Steuersignals in die Schwingungen der Membran vorteilhaft. Die zwischen dem Körper und der Membran angeordnete Verbindungsschicht ist daher vorzugsweise steif, d. h. nicht elastisch. Die Verbindungsschicht ist vorzugsweise derart ausgebildet, dass die Unterseite des Körper vollflächig, also ohne Hohlräume oder Aussparungen, mit der Membran verbunden ist. Zur Einstellung des gewünschten Wirkungsgrades kann jedoch mindestens eine Aussparung z. B. zwischen dem neutralen Bereich des Körpers und der Membran vorgesehen sein.

Die Verbindungsschicht bzw. Haftschicht ist vorzugsweise dünn, z. B. maximal 20 Mikrometer dick, in einer vorteilhaften Variante 5 bis 10 Mikrometer dick. Die Haftschicht ist vorzugsweise elektrisch isolierend.

Durch eine geeignete Dimensionierung des neutralen Bereichs des Körpers kann der Wirkungsgrad der Bauelementanordnung auch erhöht werden. Beispielsweise wird die in Längsrichtung des Körpers gemessene Breite des neutralen Bereichs größer als die zur mechanischen Entkopplung der Wandlerelemente voneinander erforderliche Mindestbreite gewählt. Die Mindestbreite des neutralen Bereichs beträgt in einer Variante 200 Mikrometer. Die Breite des neutralen Bereichs beträgt vorzugsweise maximal 500 Mikrometer, in einer vorteilhaften Variante maximal 300 Mikrometer.

Es ist vorteilhaft, den Abstand zwischen den Elektrodenebenen eines Wandlerelements, d. h. die Dicke der jeweiligen piezoelektrischen Schicht, in unterschiedlichen lateralen Bereichen des Körpers unterschiedlich zu wählen, um eine möglichst große Biegespannung erzielen zu können. Durch den kleineren Elektrodenabstand erhöht sich bei gleich bleibender elektrischer Spannung die Feldstärke in der jeweiligen piezoelektrischen Schicht. Daher ist es vorteilhaft, die Dicke der piezoelektrischen Schichten in solchen Bereichen des Körpers zu verringern, in denen die größere Auslenkung des Körpers zur Erzielung einer großen Biegespannung angestrebt wird. Dies ist beispielsweise in einem an der Membran nicht befestigten, von der Membran abgewandten lateralen Bereich des Körpers der Fall. Vorteilhaft ist demnach, wenn die Schichtdicke bzw. der Abstand zwischen den Elektrodenebenen in dem zur Membran gewandten Bereich des Körpers größer gewählt ist als in dem von der Membran abgewandten Bereich.

Die jeweilige piezoelektrische Schicht ist durch eine polare Achse charakterisiert. Die piezoelektrischen Schichten mit positiver und negativer Polungsrichtung sind vorzugsweise alternierend übereinander angeordnet.

Die piezoelektrischen Schichten des Körpers werden zur Einstellung einer Vorzugsrichtung von Domänen, die eine Polarisation aufweisen, vorpolarisiert. Das Polarisationsfeld beträgt z. B. 1 bis 3 KV/mm. Im Betrieb kann pro Schicht ein elektrisches Feld bis 200 V/mm erreicht werden.

Es ist vorteilhaft, zur Einstellung eines Arbeitspunktes an die jeweilige piezoelektrische Schicht eine Gleichspannung mit einem Vorzeichen anzulegen, bei dem das elektrische Feld mit der Polarisationsrichtung dieser Schicht übereinstimmt.

In einer vorteilhaften Variante sind die Polarisationsachsen der jeweiligen piezoelektrischen Schicht im Bereich des ersten und des zweiten Wandlerelements gleichsinnig gerichtet. Dies ist beispielsweise der Fall, wenn bei der Erzeugung einer Vorpolarisation die Polarisationsspannung an eine Parallelschaltung der Wandlerelemente angelegt wurde.

In einer weiteren vorteilhaften Variante sind die Polarisationsachsen der jeweiligen piezoelektrischen Schicht im Bereich des ersten und des zweiten Wandlerelements gegensinnig gerichtet. Dies ist beispielsweise der Fall, wenn bei der Erzeugung einer Vorpolarisation die Polarisationsspannung an eine Serienschaltung der Wandlerelemente angelegt wurde.

In einer Variante wird die Steuerspannung beim Betrieb des piezoelektrischen Bauelements so angelegt, dass das elektrische Feld in der jeweiligen piezoelektrischen Schicht im Bereich des ersten und des zweiten Wandlerelements gleichsinnig gerichtet ist. Dies ist beispielsweise der Fall, wenn an die Parallelschaltung der Wandlerelemente eine elektrische Vorspannung angelegt wird.

In einer weiteren Variante wird die Steuerspannung beim Betrieb des piezoelektrischen Bauelements so angelegt, dass das elektrische Feld in der jeweiligen piezoelektrischen Schicht im Bereich des ersten und des zweiten Wandlerelements gegensinnig gerichtet ist. Dies ist beispielsweise der Fall, wenn an die Serienschaltung der Wandlerelemente eine elektrische Vorspannung angelegt wird.

Die Polungsrichtung der Betriebsspannung kann parallel zur Ausrichtung der polaren Achse der jeweiligen piezoelektrischen Schicht sein, wobei die Polarisationsachse und das elektrische Feld gleichsinnig gerichtet sind. Die Polungsrichtung der Betriebsspannung und die Ausrichtung der polaren Achse kann auch antiparallel sein, wobei die Polarisationsachse und das elektrische Feld entgegengesetzt zueinander gerichtet sind.

In einer vorteilhaften Variante wird sowohl bei der Erzeugung der Vorpolarisation piezoelektrischer Schichten die Polarisationsspannung als auch im Betrieb die Steuerspannung an die Serienschaltung oder an die Parallelschaltung der Wandlerelemente angelegt. In diesem Fall ist die Polungsrichtung der Betriebsspannung und die Ausrichtung der polaren Achse der jeweiligen piezoelektrischen Schicht in den beiden nebeneinander angeordneten Wandlerelementen parallel.

In einer weiteren Variante ist es möglich, bei der Erzeugung der Vorpolarisation die Polarisationsspannung an die Serienschaltung der Wandlerelemente und im Betrieb die Steuerspannung an die Parallelschaltung der Wandlerelemente anzulegen. Alternativ ist es möglich, bei der Erzeugung der Vorpolarisation die Polarisationsspannung an die Parallelschaltung der Wandlerelemente und im Betrieb die Steuerspannung an die Serienschaltung der Wandlerelemente anzulegen. In diesem Fall ist die Polungsrichtung der Betriebsspannung und die Ausrichtung der polaren Achse der jeweiligen piezoelektrischen Schicht im ersten Wandlerelement parallel, wohingegen die Polungsrichtung der Betriebsspannung und die Ausrichtung der polaren Achse der jeweiligen piezoelektrischen Schicht im zweiten Wandlerelement antiparallel ist.

Die DC-Vorspannung des jeweiligen Wandlerelements ist in einer vorteilhaften Variante frequenzabhängig. Die frequenzabhängige Steuerspannung, die an das piezoelektrische Bauelement angelegt wird, kann durch einen in einem Signalpfad angeordneten Treiber erzeugt werden. Der Signalpfad ist an das jeweilige Wandlerelement angeschlossen und zur Zuführung einer Steuerspannung dem jeweiligen Wandlerelement vorgesehen.

Die unterschiedlichen Wandlerelemente des piezoelektrischen Bauelements können durch unterschiedliche DC-Steuerspannungen vorgespannt sein. Dadurch kann der Frequenzgang der Lautsprecheranordnung gezielt verflacht werden. Zwischen dem Audiochip, der ein akustisches Nutzsignal liefert, und dem piezoelektrischen Bauelement, das mit dem Nutzsignal angetrieben wird, kann z. B. ein Treiber angeordnet sein, der ausgangsseitig mindestens zwei Signalpfade aufweist. Jeder Signalpfad ist an das jeweilige Wandlerelement angeschlossen und zur Ansteuerung dieses Wandlerelements vorgesehen. Im jeweiligen Signalpfad des Treibers wird das akustische Nutzsignal mit einer vorzugsweise frequenzabhängigen DC-Steuerspannung überlagert, so dass das Wandlerelement mit einem überlagerten Steuersignal angesteuert wird. Durch die Einstellung der jeweiligen DC-Steuerspannung wird der Arbeitspunkt des jeweiligen Wandlerelements gewählt.

In einer Variante ist es vorgesehen, dass eine erste frequenzabhängige Steuerspannung mit der niedriger werdenden Frequenz des Nutzsignals ansteigt und eine zweite frequenzabhängige Steuerspannung mit der höher werdenden Frequenz des Nutzsignals ansteigt. Der erste Signalpfad ist zur Ansteuerung der zu der Membran gewandten Wandlerelemente und der zweite Signalpfad zur Ansteuerung der von der Membran abgewandten Wandlerelemente des piezoelektrischen Bauelements vorgesehen.

Es besteht die Möglichkeit, das akustische Nutzsignal zur Einstellung von mindestens zwei verschiedenen DC-Steuerspannungen zu benutzen, die zur Vorspannung der Wandlerelemente verwendet werden.

Verschiedene Bereiche des piezoelektrischen Bauelements, z. B. seine nebeneinander oder übereinander angeordneten Bereiche bzw. Wandlerelemente, können zur Ansteuerung durch Signale mit voneinander unterschiedlichen Frequenzbereichen, z. B. mit dem niederfrequenten und dem höherfrequenten Anteil des Nutzsignalspektrums, vorgesehen sein.

In einer Variante werden die zur Membran gewandten Wandlerelemente durch eine erste frequenzabhängige Steuerspannung und die von der Membran abgewandten Wandlerelemente durch eine zweite frequenzabhängige Steuerspannung angesteuert. Die Steuerspannungsquelle für die erste Steuerspannung wird z. B. hauptsächlich durch den niederfrequenten Anteil des Nutzsignalspektrums und die Steuerspannungsquelle für die zweite Steuerspannung hauptsächlich durch den höherfrequenten Anteil des Nutzsignalspektrums angetrieben. Die erste Steuerspannung verringert sich und die zweite Steuerspannung vergrößert sich dann mit der steigenden Frequenz. Der Pegel der ersten und zweiten Steuerspannung hängt von der Amplitude des jeweiligen Anteils des Nutzsignalspektrums ab.

Die Membran ist an einem Träger aufgehängt. Bei Schwingung der Membran wird eine Schallwelle in die Umgebung ausgestrahlt. Die Membran ist in einer vorteilhaften Variante aus Metall, z. B. einer Metallfolie oder Metallblech, ausgeführt.

Ein besonders großer Hub der Membran wird erzielt, wenn die Neutralebene, an der keine Auslenkung des piezoelektrischen Bauelements erfolgt, an der Grenzfläche zwischen der Membran und dem piezoelektrischen Bauelement liegt.

Ein schwingfähiger Bereich der Membran ist in einer Variante zwischen zwei vorzugsweise gleichartig ausgebildeten piezoelektrischen Bauelementen angeordnet. Bezogen auf eine Ebene, die der Ruhelage der Membran entspricht, ist vorzugsweise eine Spiegelsymmetrie der Bauelementanordnung vorhanden. Die zueinander und zur Membran gewandten Wandlerelemente unterschiedlicher piezoelektrischer Bauelemente werden vorzugsweise in Gegenphase angesteuert.

In einer vorteilhaften Variante ist die Bauelementanordnung durch eine relativ flache Resonanzkurve charakterisiert. Es handelt sich dabei um eine mechanische Eigenschwingung der Bauelementanordnung.

Ein flacher Frequenzgang der Bauelementanordnung ist erwünscht, damit im Nutzbereich der Übertragungsfunktion, z. B. im akustischen Frequenzbereich bis ca. 6 kHz, kein "Schallleistungsloch", also Leistungseinbruch, auftritt. Die flache Resonanzcharakteristik kann durch Anregung von mindestens zwei akustischen Schwingungsmoden der Bauelementanordnung erzielt werden. Der Frequenzgang der Bauelementanordnung weist in einer vorteilhaften Variante mindestens zwei Resonanzen auf, wobei jede Resonanz vorzugsweise breit eingestellt wird.

Dies bedeutet, dass die Güte der Bauelementanordnung bezüglich der jeweiligen anzuregenden Schwingungsmode vorzugsweise relativ niedrig, beispielsweise kleiner als 150, gewählt ist. Die Bauelementanordnung wird daher so gestaltet, dass durch das piezoelektrische Bauelement vorzugsweise mindestens zwei Schwingungsmoden angeregt werden.

Die Aufteilung des piezoelektrischen Bauelements in mindestens zwei unterschiedliche, aber in einem Körper integrierte Wandlerelemente ist zur Einstellung eines flachen Frequenzgangs der Bauelementanordnung besonders vorteilhaft. Die Wandlerelemente sind vorzugsweise unabhängig voneinander ansteuerbar und/oder unterschiedlich ausgestaltet. Die Wandlerelemente können dabei nebeneinander oder übereinander angeordnet sein.

Der geeignete Frequenzgang, insbesondere die Güte der Bauelementanordnung bezüglich der jeweiligen Schwingungsmode, kann beispielsweise durch eine geeignete Ansteuerung der Wandlerelemente beeinflusst werden. Vorteilhaft ist in diesem Zusammenhang eine separate Ansteuerung unterschiedlicher Wandlerelemente des piezoelektrischen Bauelements durch eine elektrische Vorspannung, wobei für jedes Wandlerelement sein eigener Arbeitspunkt einstellbar ist, oder durch eine frequenzabhängige Steuerspannung.

Die Resonanzfrequenz und die Güte der Bauelementanordnung hängt unter anderem vom Aufbau und Aufhängung der Membran am Träger, aber auch vom Aufbau des piezoelektrischen Bauelements ab. Eine relativ niedrige Güte der Resonanz, die beispielsweise maximal 50 beträgt, wird als besonders vorteilhaft betrachtet.

Das piezoelektrische Bauelement wird in einer Variante als eine elektrische Last für einen Verstärker benutzt, der Audiosignale auf einen notwendigen Leistungspegel, z. B. ca. 1 bis 3 V und 1 A, verstärkt. Um einer starken Erwärmung eines Verstärkerchips vorzubeugen, soll die Verlustleistung an der Last unterhalb von 200 mW gehalten werden. Eine niedrige Lastkapazität von z. B. unter 2 µF ist in diesem Sinne vorteilhaft. Eine Serienschaltung der Wandlerelemente ist dafür besonders vorteilhaft.

Mit kleiner werdendem Abstand zwischen den Elektroden steigt die Feldstärke in der jeweiligen piezoelektrischen Schicht. Die im piezoelektrischen Bauelement mittels des Piezoeffekts umzusetzende Wirkleistung steigt quadratisch mit der elektrischen Feldstärke an. Da aber durch die Serienschaltung eine geringe Kapazität des piezoelektrischen Bauelements zustande kommt, kann eine geringe Verlustleistung trotz geringer Schichtdicke erzielt werden. Folglich kann bei der Serienschaltung der Wandlerelemente die Dimension, insbesondere die Dicke des piezoelektrischen Bauelements verringert werden.

Der Vorteil des angegebenen piezoelektrischen Bauelements liegt daran, dass sich ein Wandlerelement durch eine besonders niedrige Kapazität charakterisiert. Wenn eine Serienschaltung von zwei gleichen Wandlerelementen angesteuert wird, verringert sich die Kapazität auf etwa ein Viertel des Kapazitätswerts gegenüber einer Variante, bei der im Körper statt miteinander verschalteter Wandlerelemente nur ein Wandlerelement realisiert ist. Bei gleichem Spannungspegel wird die Feldstärke in der jeweiligen piezoelektrischen Schicht nur halb so groß. Da der Verlustwinkel spannungsabhängig ist, kann dabei der zu Wärmeverlusten führende Verluststrom in einer Variante um mehr als einen Faktor zehn abgesenkt werden.

Im piezoelektrischen Bauelement ist eine effiziente Wandlung der elektrischen Energie in die mechanische Energie oder umgekehrt mit einem möglichst geringen Stromverbrauch erwünscht. Im jeweiligen Wandlerelement soll dabei eine möglichst kleine Blindleistung erzeugt werden, um die Erwärmung der piezoelektrischen Schichten durch die Verlustleistung zu reduzieren und somit einer unerwünschten Depolarisierung der piezoelektrischen Schichten vorzubeugen. Die niedrige Kapazität des jeweiligen Wandlerelements ist daher vorteilhaft. Dies gilt sowohl für die Serienschaltung als auch für die Parallelschaltung der Wandlerelemente.

Die Membran ist am Träger vorzugsweise derart eingespannt, dass hauptsächlich bestimmte Schwingungsmoden der Lautsprecheranordnung anregbar sind.

Die Membran ist in einer Variante nur an ihren zwei gegenüberliegenden Enden am Träger befestigt. Die Membran kann auch entlang einer Umlaufrichtung am Träger befestigt sein. Der größte Hub wird in diesen Fällen in einem mittig angeordneten Bereich der Membran erzielt.

In einer weiteren Ausführungsform kann ein mittig angeordneter Bereich der Membran am Träger befestigt sein. Der größte Hub wird in diesem Fall in Randbereichen der Membran erzielt.

Mit einer Befestigung der Membran am Träger, wobei nicht der gesamte Umfang der Membran, sondern voneinander beabstandete Randbereiche der Membran am Träger befestigt werden, gelingt es, das Schwingungsspektrum vorteilhaft zu modifizieren, indem bevorzugt nur eine begrenzte Anzahl von Schwingungsmoden angeregt wird. Insbesondere gelingt es, als nützlich anzusehende Schwingungsmoden der Lautsprecheranordnung zu unterstützen, wohingegen bestimmte Schwingungsmoden der Lautsprecheranordnung gedämpft oder sogar ausgelöscht werden.

Die Auswahl der anzuregenden Schwingungsmoden kann außerdem durch Übereinanderstapelung von mindestens zwei voneinander unterschiedlichen Wandlerelementen erzielt werden. Das piezoelektrische Bauelement umfasst in diesem Fall vorzugsweise mindestens vier Wandlerelemente auf. Übereinander angeordnete Wandlerelemente bilden einen Wandlerelement-Stapel. Der Abstand zwischen den Elektrodenebenen ist in dem zur Membran gewandten Bereich des jeweiligen Wandlerelement-Stapels vorzugsweise größer gewählt als in dem von der Membran abgewandten Bereich.

Die Wandlerelement-Stapel sind in einer Variante über die dritten Elektroden leitend miteinander verbunden. Die dritten Elektroden erstrecken sich jeweils über beide Wandlerelement-Stapel und den neutralen Bereich.

Nebeneinander angeordnete Wandlerelemente unterschiedlicher Wandlerelement-Stapel werden vorzugsweise durch ein gemeinsames Steuersignal mit einem Wechselspannungsanteil und/oder einem Gleichspannungsanteil angesteuert. In einer vorteilhaften Variante werden nebeneinander angeordnete Wandlerelemente, die zur Membran gewandt sind, mit einem ersten Steuersignal und nebeneinander angeordnete weitere Wandlerelemente, die von der Membran abgewandt sind, mit einem zweiten Steuersignal angesteuert.

Das jeweilige Steuersignal mit einem Wechselspannungsanteil kann an die gemeinsamen Elektroden der nebeneinander angeordneten Wandlerelemente angelegt werden. An die anderen Elektroden dieser Wandlerelemente wird vorzugsweise eine Gleichspannung oder ein Null-Potential angelegt.

Alternativ können übereinander angeordnete Wandlerelemente des jeweiligen Wandlerelement-Stapels durch ein gemeinsames Steuersignal mit einem Wechselspannungsanteil und/oder Gleichspannungsanteil angesteuert werden. Das jeweilige Steuersignal mit einem Wechselspannungsanteil kann beispielsweise an die leitend miteinander verbundenen Elektroden der übereinander angeordneten Wandlerelemente angelegt werden. Das Gleichspannungssignal oder das Null-Potential wird in diesem Fall vorzugsweise an die gemeinsamen Elektroden der nebeneinander angeordneten Wandlerelemente angelegt.

Die in einem Körper realisierten, voneinander beabstandeten Wandlerelement-Stapel können im Prinzip separat voneinander angesteuert werden. Die Wandlerelement-Stapel können galvanisch voneinander getrennt sein.

Im Folgenden wird das angegebene Bauelement und seine vorteilhaften Ausgestaltungen anhand von schematischen und nicht maßstabgetreuen Figuren erläutert. Es zeigen:
Figur 1A im Querschnitt ein piezoelektrisches Bauelement mit zwei Wandlerelementen, die über floatende Elektroden leitend miteinander verbunden sind;
Figuren 1B, 1C die Ansicht einer ersten und zweiten Elektrodenebene des Bauelements gemäß der Figur 1A;
Figur 2 im Querschnitt ein piezoelektrisches Bauelement, das auf einer schwingfähigen Membran befestigt ist;
Figur 3 im Querschnitt ein piezoelektrisches Bauelement mit zwei integrierten Wandlerelementen, das auf einer schwingfähigen Membran befestigt ist;
Figur 4A im Querschnitt ein piezoelektrisches Bauelement mit zwei Wandlerelementen, die über von außen kontaktierbare Elektroden leitend miteinander verbunden sind;
Figuren 4B, 4C die Ansicht einer ersten und zweiten Elektrodenebene des Bauelements gemäß der Figur 4A;
Figur 5A eine Variante des in Fig. 4A vorgestellten Bauelements, bei dem alle elektrischen Anschlüsse zu einer Seite des Körpers weisen;
Figuren 5B, 5C die Ansicht einer ersten und zweiten Elektrodenebene des Bauelements gemäß der Figur 5A;
Figuren 5D die Ansicht eines Bauelements gemäß der Figur 5A von oben;
Figuren 6, 7, 8, 9 jeweils eine Variante zur Ansteuerung des piezoelektrischen Bauelements mit zwei Wandlerelementen;
Figur 10 Ausrichtung von Polarisationsachsen der piezoelektrischen Schichten des Bauelements bei Ansteuerung der Wandlerelemente über die gemeinsame Elektrode;
Figur 11 Ausrichtung von Polarisationsachsen der piezoelektrischen Schichten des Bauelements bei Ansteuerung der Serienschaltung der Wandlerelemente;
Figur 12A im Querschnitt eine Membran mit zwei fest mit dieser verbundenen piezoelektrischen Bauelementen, die jeweils vier Wandlerelemente aufweisen;
Figuren 12B, 12C, 12D die Ansicht von Elektrodenebenen des Bauelements gemäß der Figur 12A;
Figur 13 das Ersatzschaltbild des jeweiligen piezoelektrischen Bauelements gemäß der Figur 12A;
Figuren 14, 15 die Ansicht jeweils einer Bauelementanordnung mit einem Träger, einer darauf eingespannten Membran und einem fest mit der Membran verbundenen piezoelektrischen Bauelement.

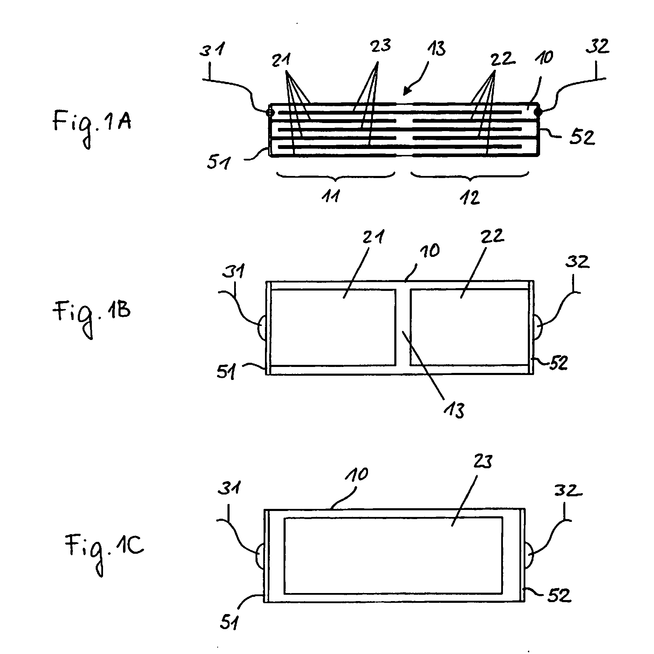

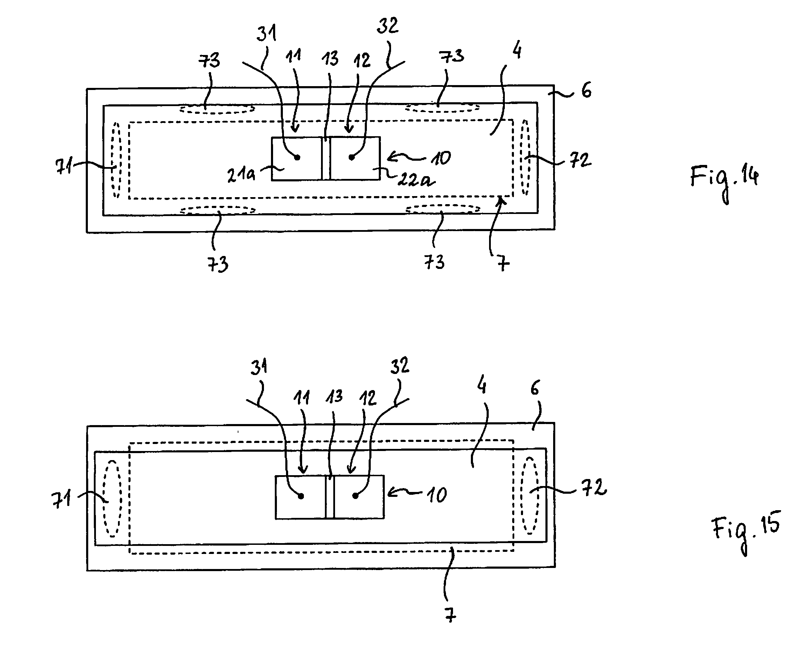

Das in den Figuren 1A bis 13 erläuterte piezoelektrische Bauelement wird beispielsweise in einer Bauelementanordnung gemäß der Figur 14 oder 15 eingesetzt. Das Bauelement ist auf einer Membran 4 befestigt, die auf einem Träger 6 eingespannt ist.

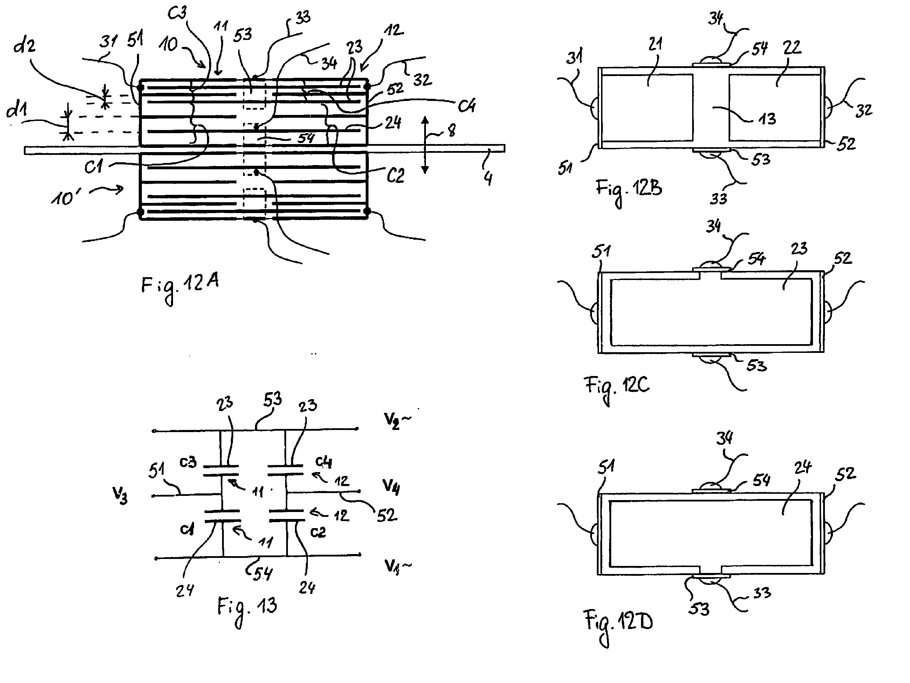

Ein Teil des schwingfähigen Bereichs der Membran 4 ist in einer Variante mit dem Körper 10 des piezoelektrischen Bauelements fest verbunden. In einer weiteren, beispielsweise in der Figur 12A vorgestellten, Variante ist ein Teil des schwingfähigen Bereichs der Membran 4 zwischen zwei vorzugsweise gleichartig ausgebildeten piezoelektrischen Bauelementen angeordnet.

Das piezoelektrische Bauelement dient vorzugsweise zur Anregung akustischer Schwingungen der Membran 4. Umgekehrt ist es möglich, das piezoelektrische Bauelement als ein Sensorelement zur Erfassung der Schwingungsamplitude einer Membran, insbesondere einer Mikrofonmembran, oder zur Erfassung eines auf die Membran wirkenden Drucks zu benutzen.

Der Körper 10 des piezoelektrischen Bauelements weist piezoelektrische Schichten und Elektrodenebenen auf, die in abwechselnder Reihenfolge übereinander angeordnet sind. Die piezoelektrischen Schichten enthalten vorzugsweise ein vorpolarisiertes Keramikmaterial.

Der Körper 10 umfasst ein erstes Wandlerelement 11, ein zweites Wandlerelement 12 und einen zwischen diesen angeordneten neutralen Bereich 13, der im Wesentlichen feldfrei ist und vorzugsweise - etwa im Gegensatz zu den Bereichen der Wandlerelemente 11 und 12 - keine Polarisationsachse aufweist.

Die Wandlerelemente 11, 12 dienen insbesondere zur Wandlung eines elektrischen Signals mit Wechselspannungsanteil in eine mechanische Schwingung, oder umgekehrt.

Der Körper 10 ist mit der Membran 4 großflächig, vorzugsweise vollflächig fest verbunden. In einer vorteilhaften Variante ist sowohl das erste Wandlerelement 11 als auch das zweite Wandlerelement 12 an die Membran 4 mechanisch angekoppelt. Somit kann die mechanische Energie der elektrisch angeregten Schwingung des Körpers 10 besonders effizient an die Membran 4 ausgekoppelt werden.

Das erste Wandlerelement 11 umfasst ein Wandlerelement C1 oder - vgl. Fig. 12A - mindestens zwei leitend miteinander verbundene Wandlerelemente C1, C3, die vorzugsweise übereinander angeordnet sind. Das zweite Wandlerelement 12 umfasst ein Wandlerelement C2 oder - vgl. Fig. 12A - mindestens zwei leitend miteinander verbundene Wandlerelemente C2, C4, die vorzugsweise übereinander angeordnet sind.

Der neutrale Bereich 13 erfährt praktisch keine mechanische Deformation beim Anlegen einer Steuerspannung an die Wandlerelemente 11, 12. Der neutrale Bereich 13 stellt daher eine Art akustischen Kurzschluss dar, der analog einem Einspannungsbereich wirkt.

Der Körper 10 ist vorzugsweise entlang seiner Längsachse in das erste Wandlerelement 11, das zweite Wandlerelement 12 und den neutralen Bereich 13 aufgeteilt. Der neutrale Bereich 13 erstreckt sich im Querschnitt in einer Vertikalrichtung, vorzugsweise senkrecht zu einer Längsachse des Körpers 10.

Der Körper 10 weist erste Elektroden 21, zweite Elektroden 22 und dritte Elektroden 23 auf. Die ersten Elektroden 21 sind mittels einer ersten elektrisch leitenden Fläche 51 leitend miteinander verbunden. Die zweiten Elektroden 22 sind mittels einer zweiten elektrisch leitenden Fläche 52 leitend miteinander verbunden.

Die ersten Elektroden 21 sind galvanisch von den zweiten und dritten Elektroden 22, 23 getrennt. Die zweiten Elektroden 22 sind galvanisch von den ersten und dritten Elektroden 21, 23 getrennt. Die dritten Elektroden 23 sind galvanisch von den ersten und zweiten Elektroden 21, 22 getrennt.

Eine einzige, vorzugsweise im Inneren des Körpers angeordnete dritte Elektrode 23 kann im Prinzip ausreichend sein, um mindestens zwei Wandlerelemente leitend zu verbinden. Mindestens eine der dritten Elektroden 23 kann aber auch auf der Oberfläche des Körpers, in einer Variante zumindest auf der zur Membran 4 gewandten Hauptfläche oder des Körpers 10, angeordnet sein.

In einer vorteilhaften Variante sind im Körper 10 mehrere dritte Elektroden 23, 24 angeordnet, die als gemeinsame Elektroden für mindestens zwei der Wandlerelemente 11, 12, C1, C2, C3, C4 vorgesehen sind. Die jeweilige dritte Elektrode ist zwischen zwei leitend miteinander verbundenen, von dritten Elektroden galvanisch getrennten Elektroden des ersten Wandlerelements 11 angeordnet. Die jeweilige dritte Elektrode ist zwischen zwei leitend miteinander verbundenen, von dritten Elektroden galvanisch getrennten Elektroden des zweiten Wandlerelements 12 angeordnet.

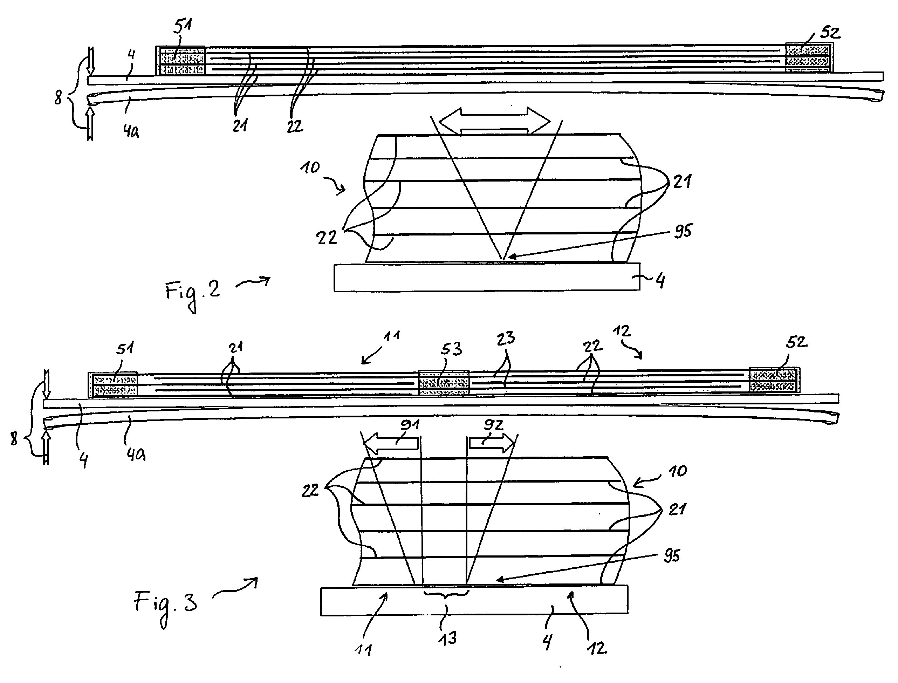

Die dritten Elektroden 23 sind in der Variante gemäß den Figuren 1A-1C floatend ausgebildet, wobei sie galvanisch voneinander getrennt sind. In den Varianten gemäß den Figuren 3, 4A-4C, 5A-5D, 12A-12D sind die dritten Elektroden 23 an eine dritte elektrisch leitende Fläche 53 und in Fig. 12A mindestens eine weitere dritte Elektrode 24 an eine weitere dritte elektrisch leitende Fläche 54 angeschlossen.

Eine auf der Oberfläche des Körpers angeordnete, elektrisch leitende Fläche 51, 52, 53, 54 kann einerseits als eine Sammelelektrode zur Verbindung von ersten, zweiten bzw. dritten Elektroden 21, 22 bzw. 23, 24 und andererseits als ein Außenanschluss des piezoelektrischen Bauelements vorgesehen sein. Die jeweilige als eine Sammelelektrode vorgesehene leitende Fläche kann grundsätzlich an eine beliebige weitere leitende Fläche angeschlossen sein, die auf der Hauptfläche des Körpers 10 angeordnet und als ein Außenanschluss des Bauelements vorgesehen ist.

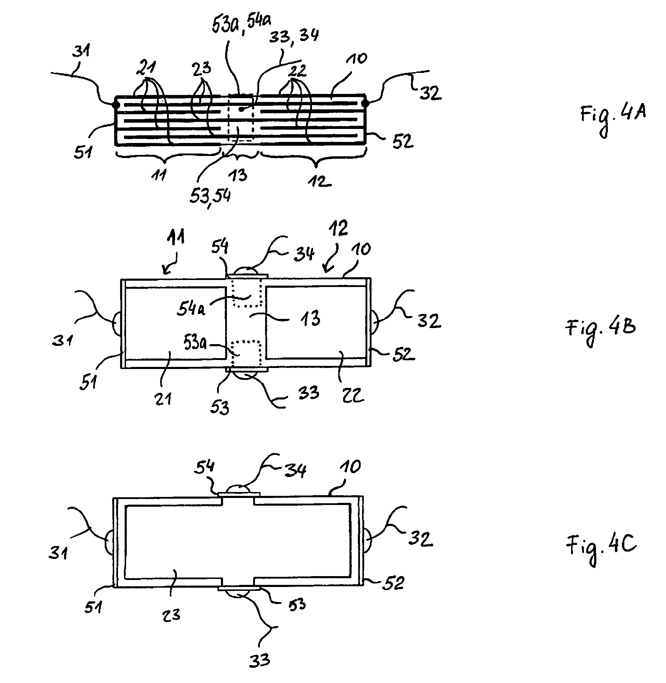

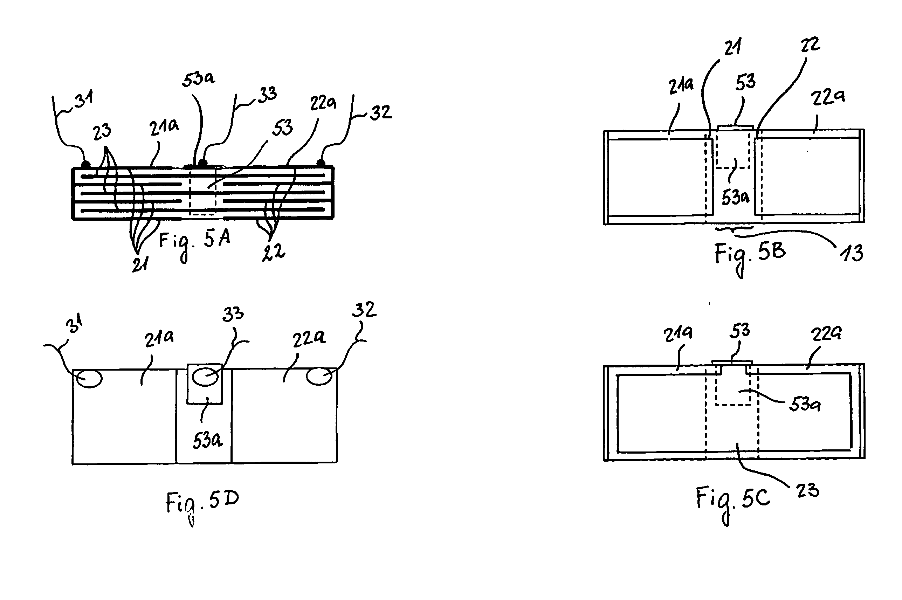

Die elektrisch leitenden Flächen 51, 52, 53, 54 sind zumindest teilweise auf Seitenflächen des Körpers 10 angeordnet. Vorteilhaft ist, wenn die leitenden Flächen möglichst weit voneinander beabstandet und z. B. auf voneinander unterschiedlichen Seitenflächen angeordnet sind. Ein Anschlussbereich der jeweiligen leitenden Fläche kann auch auf einer Hauptfläche des Körpers 10 angeordnet sein. Beispielsweise ist der Bereich 53a, 54a der leitenden Fläche 53 bzw. 54 auf einer Hauptfläche des Körpers 10 angeordnet, die nicht als Befestigungsbereich des Körpers vorgesehen ist. Siehe dazu Fig. 4A, 4B und 5A, 5B.

Am jeweiligen Außenanschluss 51 oder 21a, 52 oder 22a, 53, 54 des Bauelements ist ein Anschlussdraht 31, 32, 33 bzw. 34 befestigt.

Im Bereich des ersten Wandlerelements 11 sind die ersten Elektroden 21 und erste Bereiche der dritten Elektroden 23 in abwechselnder Reihenfolge übereinander angeordnet. Im Bereich des zweiten Wandlerelements 12 sind die zweiten Elektroden 22 und zweite Bereiche der dritten Elektroden 23 in abwechselnder Reihenfolge übereinander angeordnet. Im neutralen Bereich 13 sind nur dritte Elektroden 23 angeordnet.

Die ersten und zweiten Elektroden 21, 22 sind in den ersten Elektrodenebenen angeordnet. Die dritten Elektroden 23 sind in den zweiten Elektrodenebenen angeordnet. Die jeweilige piezoelektrische Schicht ist vorzugsweise zwischen einer ersten und einer zweiten Elektrodenebene angeordnet. Die ersten und zweiten Elektrodenebenen sind also in abwechselnder Reihenfolge übereinander angeordnet.

Die Elektrodenebenen umfassen im Körper innen liegende Ebenen sowie auf der Ober- und Unterseite des Körpers angeordnete Elektrodenebenen. Die auf der Oberseite und Unterseite des Körpers 10 angeordnete Elektrodenebene kann je nach Anwendung die erste oder die zweite Elektrodenebene sein.

Die zur Kontaktierung durch Anschlussdrähte 31, 32, 33, 34 vorgesehenen Außenanschlüsse des Bauelements sind auf Seitenflächen des Körpers 10 oder auf der von der Membran 4 abgewandten Hauptfläche angeordnet. Die Befestigung von Anschlussdrähten auf der Hauptfläche ist besonders vorteilhaft, falls der Körper 10 nur eine geringe Dicke aufweist. Beispielsweise kann ein Bereich der an der Oberfläche des Körpers 10 angeordneten Elektroden 21a, 22a und/oder einer außen liegenden dritten Elektrode als Außenanschluss des Bauelements benutzt werden.

In der Figur 1B ist die Ansicht einer ersten Elektrodenebene des Körpers 10 gezeigt. In der jeweiligen ersten Elektrodenebene ist eine erste Elektrode 21 und eine von dieser beabstandete zweite Elektrode 22 angeordnet.

In der Figur 1C ist die Ansicht einer zweiten Elektrodenebene des Körpers 10 gezeigt. In der jeweiligen zweiten Elektrodenebene ist eine dritte Elektrode 23 angeordnet.

Die dritten Elektroden 23 sind vorzugsweise allseitig, ggf. mit Ausnahme eines Anschlussbereichs an die leitenden Flächen 53 oder 54, von der Oberfläche des Körpers 10 zurückgezogen. Dies gilt in entsprechender Weise auch für die ersten und zweiten Elektroden 21, 22 und ihre Anschlussbereiche an die leitenden Flächen 51, 52.

In den Figuren 2 und 3 ist die Wirkung des Piezoeffekts in einem piezoelektrischen Bauelement, das in einem Befestigungsbereich an einer schwingfähigen Membran 4 befestigt ist, erläutert. Mit Pfeilen 8 ist die Auslenkung der durch das piezoelektrische Bauelement angetriebenen Membran 4 angedeutet. Bas Bezugszeichen 4 bezieht sich auf die Membran im Grundzustand und das Bezugszeichen 4a auf die deformierte Membran.

In der Figur 2 oben ist ein piezoelektrisches Bauelement mit ineinander greifenden ersten und zweiten Elektroden gezeigt. In der Figur 2 unten ist ein vergrößerter Abschnitt des Körpers 10 gezeigt.

In diesem Fall ist nur ein Wandlerelement vorgesehen. Mit einem Doppelpfeil ist verdeutlicht, dass beim Anlegen einer elektrischen Spannung an die Elektroden 21, 22 die Auslenkung der jeweiligen piezoelektrischen Schicht in einer Lateralebene erfolgt.

Der Körper dehnt sich oder schrumpft in einer Lateralrichtung bezüglich einer Ruhelage infolge eines kumulierten Lateraleffekts mit einer piezoelektrischen Konstante d₁₃. Dieser Effekt ist auf der zur Membran gewandten Seite des Körpers gehindert, da der Körper an der Membran 4 befestigt ist. Daher kann sich der Körper dort trotz mechanischer Spannung weder ausdehnen noch schrumpfen. Seine linearen Abmessungen im Befestigungsbereich bleiben also erhalten.

Je größer der Abstand zwischen der jeweiligen piezoelektrischen Schicht und dem Befestigungsbereich des Körpers 10 ist, desto mehr Auslenkung des piezoelektrischen Materials in Lateralrichtung ist möglich. Während die von der Membran 4 abgewandten, in der Figur 2 oberen, piezoelektrischen Schichten bei der entsprechenden Polarität der angelegten elektrischen Spannung eine Ausdehnung erfahren, erfahren die zur Membran 4 gewandten piezoelektrischen Schichten einen Stress. Die bezogen auf die Vertikalrichtung ungleichmäßige laterale Auslenkung des Körpers 10 führt zu Biegedeformationen des Körpers, weswegen Schwingungen der Membran 4 hervorgerufen werden können.

In der Figur 3 ist ein piezoelektrisches Bauelement mit zwei mittels den gemeinsamen dritten Elektroden 23 leitend miteinander verbundenen Wandlerelementen 11, 12 gezeigt. In der Figur 3 unten ist ein vergrößerter Abschnitt des Körpers 10 gezeigt.

Mit dem Pfeil 91 ist die Richtung der lateralen Auslenkung des Körpers im Bereich des ersten Wandlerelements 11 und mit dem Pfeil 92 die Richtung der lateralen Auslenkung des Körpers im Bereich des zweiten Wandlerelements 12 verdeutlicht. Diese Auslenkung kommt beim Anlegen einer elektrischen Spannung an die Elektroden 21, 22 und/oder ggf. an die Elektrode 23 zustande.

Der neutrale Bereich 13 ist feldfrei und im Wesentlichen frei von mechanischen Spannungen, da das Material der jeweiligen piezoelektrischen Schicht in diesem Bereich nicht vorpolarisiert ist. Die piezoelektrischen Schichten sind im neutralen Bereich 13 quasi eingespannt. Da im neutralen Bereich keine Auslenkung möglich ist, wird die Auslenkung des Körpers an seinem vom neutralen Bereich abgewandten, frei liegenden Ende um so größer.

Das in den Figuren 4A bis 4C vorgestellte piezoelektrische Bauelement ist bezogen auf eine Ebene, die senkrecht zur Längsachse des Körpers 10 verläuft, im Wesentlichen spiegelsymmetrisch aufgebaut. Das Bauelement ist außerdem bezogen auf eine Ebene, die senkrecht zu den Elektroden ausgerichtet ist und in der die Längsachse des Körpers 10 liegt, spiegelsymmetrisch aufgebaut. Die jeweilige dritte Elektrode 23 ist sowohl an die dritte leitende Fläche 53 als auch an die weitere dritte leitende Fläche 54 angeschlossen und im Prinzip über beide leitenden Flächen 53, 54 oder eine dieser Flächen kontaktierbar.

Die Anschlussdrähte 31, 32, 33, 34 sind hier auf den leitenden Flächen 51, 52, 53, 54 befestigt, die an den Seitenflächen des Körpers 10 angeordnet sind. Alternativ kann der Anschlussdraht 31 wie in der Variante gemäß der Figur 5A an der durch die oberste erste Elektrode 21a gebildeten leitenden Fläche, der Anschlussdraht 32 an der durch die oberste zweite Elektrode 22a gebildeten leitenden Fläche, der Anschlussdraht 33 im Bereich 53a der leitenden Fläche 53 und der Anschlussdraht 34 im Bereich 54a der leitenden Fläche 54 befestigt sein.

Auf die optionalen Bereiche 53a, 54a der leitenden Flächen 53, 54 kann in allen Varianten im Prinzip verzichtet werden.

Falls erforderlich, beispielsweise wenn der neutrale Bereich eine Breite von < 500 Mikrometern aufweist, kann der als eine Anschlussfläche vorgesehene Bereich 53a, 54a im Wesentlichen so breit wie der neutrale Bereich 13 oder sogar breiter als der neutrale Bereich 13 ausgebildet sein, um eine ausreichende Anschlussfläche für den Anschlussdraht 33, 34 gewährleisten zu können. Die erste und zweite Elektrode 21a, 22a, die in der gleichen Elektrodenebene mit der leitenden Fläche 53a, 54a liegen, sind entsprechend zurückgezogen und bezogen auf die Längsachse des Körpers kürzer ausgebildet als in den innen liegenden Elektrodenebenen. Die außen liegenden Elektroden 21a, 22a können, müssen aber nicht von den Kanten bzw. Seitenflächen des Körpers 10 zurückgezogen sein.

In der in den Figuren 5A bis 5D vorgestellten Variante weisen alle elektrischen Anschlüsse des Bauelements zu einer Seite des Körpers 10. Alle elektrischen Anschlüsse sind dabei auf der Oberseite des Körpers angeordnet. Die auf der Oberseite des Körpers angeordneten Elektroden 21a, 22a sind bezogen auf die Längsachse des Körpers kürzer ausgebildet als erste und zweite Elektroden 21, 22 in den innen liegenden Elektrodenebenen. Die auf der Oberseite des Körpers angeordneten Elektroden 21a, 22a sind jedoch bezogen auf eine Breitenrichtung des Körpers breiter ausgebildet als erste und zweite Elektroden 21, 22.

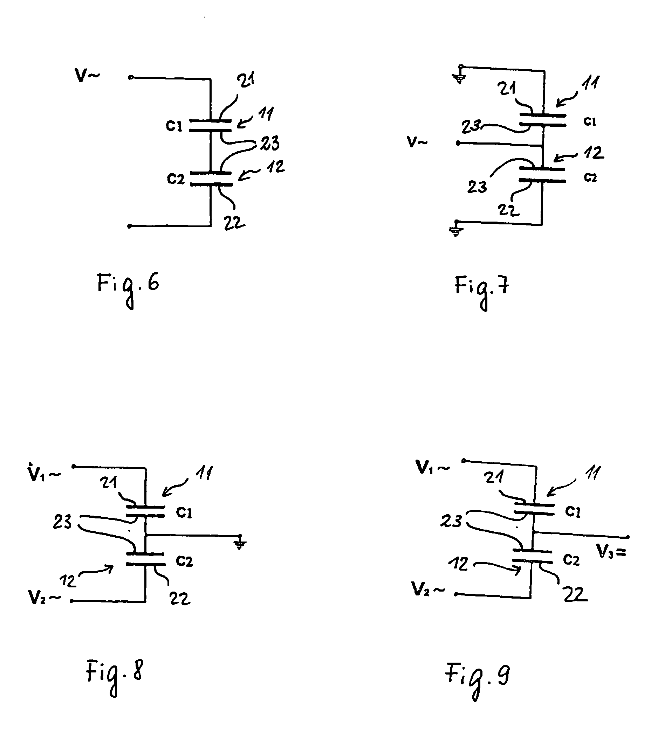

In den Figuren 6 bis 9 sind verschiedene Beschaltungs- und Ansteuerungsmöglichkeiten der Wandlerelemente 11, 12 vorgestellt. Die jeweilige Variante kann einerseits zur Erzeugung einer Vorpolarisation der piezoelektrischen Schichten im Bereich der Wandlerelemente 11 und 12 verwendet werden, wobei bei einer relativ hohen Temperatur oberhalb des Curie-Punktes eine relativ große Gleichspannung als Polarisationsspannung angelegt wird. Die Ausrichtung der Polarisationsachse in der jeweiligen piezoelektrischen Schicht hängt von der Polarität der angelegten Polarisationsspannung ab.

Die jeweilige Variante kann andererseits zur Ansteuerung durch ein Steuersignal mit einem Wechselspannungsanteil verwendet werden. Mit dem Symbol "∼" ist angedeutet, dass das Steuersignal einen Wechselspannungsanteil aufweist. Mit dem Symbol "=" ist angedeutet, dass das Steuersignal einen Gleichspannungsanteil aufweist.

In der Variante gemäß der Figur 6 wird eine Polarisationsspannung oder ein Steuersignal V∼ an eine Serienschaltung der Wandlerelemente 11, 12 bzw. C1, C2 angelegt. In dieser Variante werden die gemeinsamen Elektroden 23, ob jeweils floatend ausgebildet oder leitend untereinander verbunden, nicht mit einer externen Schaltung verbunden.

In der Variante gemäß der Figur 7 wird eine Polarisationsspannung oder ein gemeinsames Steuersignal V∼ an die gemeinsamen Elektroden 23 der beiden Wandlerelemente 11, 12 bzw. C1, C2 angelegt. Die ersten Elektroden 21 sind mit einem ersten Bezugspotential und die zweiten Elektroden 22 mit einem zweiten Bezugspotential verbunden. Das jeweilige Bezugspotential kann z. B. Masse, ein Null-Potential oder eine Gleichspannung mit positiver oder negativer Polarität sein.

Voneinander unterschiedliche Bezugspotentiale für das erste und das zweite Wandlerelement 11, 12 können vorteilhaft sein. Das erste Bezugspotential kann aber auch mit dem zweiten Bezugspotential identisch sein. Im letzteren Fall sind die Wandlerelemente 11, 12 elektrisch parallel geschaltet.

In der Variante gemäß den Figuren 8, 9 wird eine erste Polarisationsspannung oder ein erstes Steuersignal V₁∼ an die ersten Elektroden 21 des ersten Wandlerelements 11 angelegt. Eine zweite Polarisationsspannung oder ein zweites Steuersignal V₂∼ wird an die zweiten Elektroden 22 des zweiten Wandlerelements 12 angelegt. Die gemeinsamen Elektroden 23 der Wandlerelemente 11, 12 sind dabei vorzugsweise mit einem Bezugspotential verbunden. In der Figur 8 ist dies ein Null-Potential oder Masse. In der Figur 9 ist dies ein positives oder negatives DC-Signal V₃=. Die Bezeichnung positiv oder negativ für das Bezugspotential bezieht sich auf die Masse der Bauelementanordnung, in der das piezoelektrische Bauelement eingesetzt wird.

Die Signale V₁∼ und V₂∼ können beispielsweise zusammen ein Stereosignal ergeben.

Das an die ersten, zweiten oder dritten Elektroden angelegte Steuersignal kann grundsätzlich abgesehen vom AC-Anteil, beispielsweise zur Erzeugung einer Vorspannung der Wandlerelemente 11, 12 und zur Einstellung eines Arbeitspunktes, einen DC-Anteil enthalten. Das an die ersten, zweiten oder dritten Elektroden angelegte Steuersignal stellt dabei die Summe des AC-Anteils und des DC-Anteils dar.

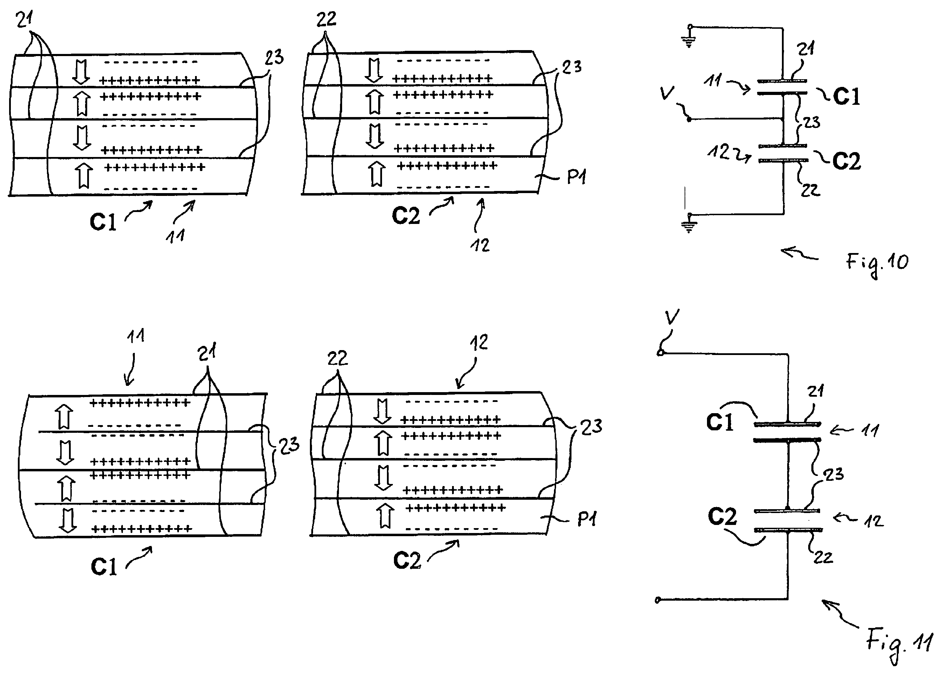

In der Figur 10 ist mit Blockpfeilen die Ausrichtung der Polarisation der jeweiligen piezoelektrischen Schicht bei der Ansteuerung der Wandlerelemente 11, 12 durch ein Steuersignal V mit einer vorgegebenen Polarität angedeutet. Die Ansteuerung erfolgt über die gemeinsamen Elektroden 23. Das Potential der Elektroden 23 ist in diesem Fall wohl definiert, und zwar in der gezeigten Variante bezüglich des Potentials der ersten und zweiten Elektroden 21, 22 positiv eingestellt. Bei Ansteuerung der Elektroden 23 durch ein negatives Potential stellt sich in jeder piezoelektrischen Schicht eine gegenüber der gezeigten Polarisationsrichtung entgegengesetzt gerichtete Polarisation ein.

Die jeweilige piezoelektrische Schicht, beispielsweise die unterste Schicht P1, weist in diesem Fall die gleiche Polarisationsrichtung (nach oben) im Bereich des ersten und des zweiten Wandlerelements 11, 12 auf.

In der Figur 11 ist mit Blockpfeilen die Polarisationsrichtung der jeweiligen piezoelektrischen Schicht bei der Ansteuerung der Serienschaltung der Wandlerelemente 11, 12 durch ein Steuersignal V mit einer vorgegebenen Polarität angedeutet. Die Polarisationsrichtungen im Bereich des ersten und des zweiten Wandlerelements 11, 12 sind relativ zueinander antiparallel. Da die dritten Elektroden 23 in diesem Fall floatend oder zumindest nicht mit einem bestimmten Potential verbunden sind, stellt sich das Potential der jeweiligen dritten Elektrode 23 frei ein. Dieses Potential ist im Bereich des ersten Wandlerelements 11 - bezogen auf das Potential der ersten Elektroden 21 - negativ und im Bereich des zweiten Wandlerelements 12 - bezogen auf das Potential der zweiten Elektroden 22 - positiv.

In der Variante gemäß der Figur 12A ist die Membran 4 zwischen zwei gleichartig ausgebildeten piezoelektrischen Bauelementen angeordnet. Der Körper 10' des zweiten piezoelektrischen Bauelements weist im Wesentlichen die gleichen Eigenschaften wie der Körper 10 des nachstehend erläuterten ersten piezoelektrischen Bauelements auf.

In der Variante gemäß der Figur 12A umfasst das erste Wandlerelement 11 zwei leitend miteinander verbundene, übereinander angeordnete Wandlerelemente C1, C3. Das zweite Wandlerelement 12 weist zwei leitend miteinander verbundene, übereinander angeordnete Wandlerelemente C2, C4 auf.

Die Dicke der piezoelektrischen Schichten im Bereich der Wandlerelemente C1 und C2 beträgt d1. Die Wandlerelemente C3, C4 weisen piezoelektrische Schichten mit einer geringeren Dicke d2 als die Wandlerelemente C1, C2 auf. Die Wandlerelemente C1 und C2 mit den relativ dicken piezoelektrischen Schichten sind zur Membran 4 gewandt. Die Wandlerelemente C3 und C4 mit den relativ dünnen piezoelektrischen Schichten sind von der Membran 4 abgewandt.

Mit einem kleineren Abstand zwischen den unterschiedlich gepolten Elektroden in dem von der Membran 4 abgewandten Bereich des Körpers 10 gelingt es, eine größere Auslenkungsamplitude des piezoelektrischen Materials zu erzielen. Durch die Änderung des Abstands zwischen den Elektroden im oberen Bereich des jeweiligen Wandlerelements 11, 12 relativ zu seinem unteren Bereich gelingt daher eine besonders effiziente elektromechanische Wandlung.

Das Ersatzschaltbild des piezoelektrischen Bauelements gemäß der in Fig. 12A bis 12C gezeigten Variante ist in der Figur 13 gezeigt.

Das erste und zweite Steuersignal V₁∼ und V₂∼ wird vorzugsweise an die gemeinsamen Elektroden der nebeneinander angeordneten Wandlerelemente angelegt. Das Steuersignal V₁∼ wird an die gemeinsame Elektrode 24 der Wandlerelemente C1 und C2 und das Steuersignal V₂∼ an die gemeinsamen Elektroden 23 der Wandlerelemente C3 und C4 angelegt.

Das dritte und vierte Steuersignal V₃ und V₄ wird vorzugsweise an die gemeinsamen Elektroden der übereinander angeordneten Wandlerelemente angelegt. Das Steuersignal V₃ wird an die ersten Elektroden 21 der Wandlerelemente C1 und C3 und das Steuersignal V₄ an die zweiten Elektroden 22 der Wandlerelemente C2 und C4 angelegt.

Das jeweilige Steuersignal V₁∼, V₂∼ V₃, V₄ kann je nach Variante ein Bezugspotential, eine Gleichspannung, eine Wechselspannung oder ein überlagertes Signal sein. Vorzugsweise enthalten zumindest die Steuersignale V₁∼ und V₂∼ ein akustisches Nutzsignal. Die Steuersignale V₃ und V₄ enthalten vorzugsweise einen DC-Anteil oder sind identisch mit einem Bezugspotential.

Die Steuersignale V₃ und V₄ können durch ein gemeinsames Steuersignal ersetzt werden. Die Steuersignale V₁∼ und V₂∼ können auch durch ein gemeinsames Steuersignal ersetzt werden.

Anstelle nur einer dritten Elektrode 24 können im Bereich der Wandlerelemente C1, C2 mehrere gemeinsame Elektroden 24 vorgesehen sein. Umgekehrt gilt, dass anstelle einer Anzahl von dritten Elektrode 23 im Bereich der Wandlerelemente C3, C4 nur eine gemeinsame Elektrode 23 vorgesehen sein kann.

Im Prinzip besteht die Möglichkeit, an die Wandlerelemente C1, C2 eine erste Vorspannung und an die Wandlerelemente C3, C4 eine zweite Vorspannung anzulegen. Dies kann zur bevorzugten Anregung einer bestimmten Schwingungsmode der Bauelementanordnung vorteilhaft sein. In diesem Fall ist eine separate Kontaktierung der dritten Elektroden 23 und der weiteren dritten Elektroden 24 über die galvanisch voneinander getrennten leitenden Flächen 53 bzw. 54 vorteilhaft.

Als eine Sammelelektrode zur Verbindung der dritten Elektroden 23 ist eine dritte leitende Fläche 53 vorgesehen. Die an die weitere dritte Elektrode 24 angeschlossene weitere dritte leitende Fläche 54 kann auch als eine Sammelelektrode zur Verbindung mehrerer dritter Elektroden 24 vorgesehen sein. Im Prinzip besteht die Möglichkeit, alle dritten Elektroden 23, 24 innerhalb des Körpers leitend miteinander zu verbinden. Beispielsweise können alle dritten Elektroden 23, 24 an eine der leitenden Flächen 53, 54 oder an beide leitenden Flächen 53, 54 angeschlossen sein.

Die dritten leitenden Flächen 53, 54 sind in der Variante gemäß den Figuren 12A-12C auf gegenüber liegenden Seitenflächen des Körpers 10 angeordnet. Die dritten leitenden Flächen können auch auf ein und derselben Seitenfläche des Körpers 10 angeordnet sein.

Das Wandlerelement C1 weist in allen Varianten vorzugsweise die gleichen Eigenschaften wie das neben ihm angeordnete zweite Wandlerelement C2 auf. Dies bezieht sich insbesondere auf den Kapazitätswert der Wandlerelemente. In der in Fig. 12A-12C, 13 vorgestellten Variante sind die Wandlerelemente C1 und C2 vorzugsweise untereinander gleich, aber von den Wandlerelementen C3 und C4 unterschiedlich ausgebildet. Die Wandlerelemente C3 und C4 sind vorzugsweise untereinander gleich ausgebildet.

Obwohl in der Variante gemäß der Figur 12A das Wandlerelement 11, 12 als ein Wandlerelement-Stapel mit nur zwei Wandlerelementen dargestellt ist, können im Körper 10 auch mehr als nur zwei Wandlerelemente zur Bildung eines Wandlerelement-Stapels übereinander angeordnet sein. Dabei sind vorzugsweise alle Wandlerelemente des jeweiligen Stapels mit ein und demselben elektrischen Potential verbunden oder werden durch ein gemeinsames Steuersignal angesteuert. Die Ansteuerung einer Parallelschaltung der übereinander angeordneten Wandlerelemente durch ein gemeinsames Steuersignal ist besonders vorteilhaft.

In der Figur 14 ist eine Bauelementanordnung, insbesondere eine Lautsprecheranordnung oder eine Mikrofon-Anordnung, vorgestellt. Die Bauelementanordnung umfasst einen Träger 6 und eine Membran 4. Im Träger 6 ist eine Ausnehmung 7 oder Öffnung ausgebildet, über der ein nicht befestigter Bereich der Membran 4 schwingen kann. Außerhalb des schwingfähigen Bereichs der Membran 4 sind Befestigungsbereiche 71, 72, 73 vorgesehen, in denen die Membran 4 mit dem Träger 6 beispielsweise mittels einer Haftschicht fest verbunden ist.

Die Befestigungsbereiche 71, 72, 73 sind voneinander beabstandet. In der Variante gemäß der Figur 15 ist die Membran 4 nur an ihren zwei gegenüber liegenden Seiten am Träger 6 eingespannt, siehe Befestigungsbereiche 71 und 72. Zwei Seiten der Membran 4 sind nicht eingespannt und können daher frei schwingen. In diesem Fall ist die Breite der Ausnehmung 7 vorzugsweise größer als die Breite der Membran 4.

In einer weiteren Variante ist statt mehrerer Befestigungsbereiche nur ein umlaufender Befestigungsbereich ausgebildet.

Die Ausgestaltung des Bauelements und der Bauelementanordnung, insbesondere bezüglich der Anzahl und der Form der gezeigten Komponenten, ist auf die in den Figuren gezeigten Beispiele nicht beschränkt. Die Materialangaben stellen keine Einschränkung zur Ausgestaltung des Bauelements dar.

Anstelle einer Membran kann eine andere zur Auskopplung der akustischen Energie geeignete, vorzugsweise schwingfähige Komponente, z. B. ein Resonanzkörper oder ein Halterungselement, benutzt werden.

In der Variante gemäß der Figur 12A sind bezogen auf die Paare der Wandlerelemente C1 und C2, C3 und C4 oder C1 und C3, C2 und C4 die Ansteuerungsvarianten gemäß den Figuren 6, 7, 8, 9 möglich. Unterschiedliche Paare können galvanisch miteinander verbunden oder galvanisch voneinander getrennt sein.

### Bezugszeichenliste

- 10: Körper des ersten piezoelektrischen Bauelements
- 10': Körper des zweiten piezoelektrischen Bauelements
- 11: erstes Wandlerelement
- 12: zweites Wandlerelement
- 13: neutraler Bereich des Körpers
- 21: erste Elektroden
- 21a: außen liegende erste Elektrode
- 22: zweite Elektroden
- 22a: außen liegende zweite Elektrode
- 23: dritte Elektroden
- 24: weitere dritte Elektrode
- 31, 32, 33, 34: Anschlussdrähte
- 4: Membran im Ausgangszustand
- 4a: deformierte Membran
- 51: Sammelelektrode zur Verbindung von ersten Elektroden 21
- 52: Sammelelektrode zur Verbindung von zweiten Elektroden 22
- 53: Sammelelektrode zur Verbindung von dritten Elektroden 23
- 53a: Anschlussbereich der Sammelelektrode 53
- 54: Außenanschluss zur Kontaktierung der weiteren dritten Elektrode 24
- 54a: Anschlussbereich der Sammelelektrode 54
- 6: Träger
- 7: Ausnehmung im Träger
- 71, 72, 73: Befestigungsbereiche der Membran am Träger
- 8: Richtung der Auslenkung der Membran 4
- 91, 92: Richtung der lateralen Auslenkung des Körpers 10
- C1, C2, C3, C4: Wandlerelemente
- d1, d2: Abstand zwischen den aufeinander folgenden Elektroden
- P1: piezoelektrische Schicht
- V: Steuersignal
- V∼, V₁∼, V₂∼: Steuersignale mit einem Wechselspannungsanteil
- V₃, V₃₌, V₄: Steuersignale mit einem DC-Anteil

## Patentansprüche

1. Piezoelektrisches Bauelement
- mit einem Körper (10), in dem elektrisch miteinander verbundene Wandlerelemente (11, 12, C1, C2, C3, C4) realisiert sind, die durch einen im Wesentlichen feldfreien neutralen Bereich (13) des Körpers voneinander beabstandet sind,
- wobei ein erstes Wandlerelement (11) leitend miteinander verbundene erste Elektroden (21) und ein zweites Wandlerelement (12) leitend miteinander verbundene zweite Elektroden (22) aufweist,
- wobei mindestens eine dritte Elektrode (23) vorgesehen ist, die im ersten und zweiten Wandlerelement (11, 12) angeordnet ist,
- wobei mindestens drei Elektroden, ausgewählt aus den ersten und dritten Elektroden (21, 23), in einer alternierenden Reihenfolge angeordnet sind, und wobei mindestens drei Elektroden, ausgewählt aus den zweiten und dritten Elektroden (22, 23), in einer alternierenden Reihenfolge angeordnet sind,
- wobei der neutrale Bereich (13) senkrecht zu den Ebenen ausgerichtet ist, in denen die Elektroden (21, 22, 23) angeordnet sind,
- wobei der Körper (10) piezoelektrische Schichten (P1) aufweist und **dadurch gekennzeichnet ist, dass**
- die Schichtstärke der piezoelektrischen Schichten in einem ersten lateralen Bereich des Körpers (10) größer ist als diejenige in einem zweiten lateralen Bereich des Körpers (10).

2. Bauelement nach Anspruch 1,
- wobei der Körper (11) als eine Platte ausgebildet ist.

3. Bauelement nach einem der Ansprüche 1 oder 2,
- wobei die dritten Elektroden (23) als Blindelektroden ausgebildet sind.

4. Bauelement nach einem der Ansprüche 1 bis 3,
- wobei an die ersten Elektroden (21) ein erstes Steuersignal (V₁∼) und an die zweiten Elektroden (22) ein zweites Steuersignal (V₂∼) angelegt wird.

5. Bauelement nach einem der Ansprüche 1 bis 4,
- wobei die Polarisationsachsen der jeweiligen piezoelektrischen Schicht (P1) im Bereich des ersten und des zweiten Wandlerelements (11, 12, C1, C2) gleichsinnig oder gegensinnig gerichtet sind.

6. Bauelementanordnung
- mit mindestens einem piezoelektrischen Bauelement nach einem der Ansprüche 1 bis 5,
- mit einer schwingfähigen Membran (4), auf der das Bauelement befestigt ist.

7. Bauelementanordnung nach Anspruch 6,
- wobei ein Bereich der Membran (4) zwischen zwei piezoelektrischen Bauelementen angeordnet ist.

8. Bauelementanordnung nach einem der Ansprüche 6 oder 7,
- wobei die Membran (4) an einem Träger (6) in mindestens zwei voneinander beabstandeten Bereichen (71, 72, 73) aufgehängt ist.

## Claims

1. Piezoelectric component
- comprising a body (10), in which transducer elements (11, 12, C1, C2, C3, C4) electrically connected to one another are realized, said transducer elements being spaced apart from one another by a substantially field-free neutral region (13) of the body,
- wherein a first transducer element (11) has first electrodes (21) conductively connected to one another, and a second transducer element (12) has second electrodes (22) conductively connected to one another,
- wherein at least one third electrode (23) is provided which is arranged in the first and second transducer elements (11, 12),
- wherein at least three electrodes, selected from the first and third electrodes (21, 23), are arranged in an alternating order, and wherein at least three electrodes, selected from the second and third electrodes (22, 23), are arranged in an alternating order,
- wherein the neutral region (13) is aligned perpendicularly to the planes in which the electrodes (21, 22, 23) are arranged,
- wherein the body (10) has piezoelectric layers (P1), and
- **characterized in that** the layer thickness of the piezoelectric layers in a first lateral region of the body (10) is greater than that in a second lateral region of the body (10).

2. Component according to Claim 1,
- wherein the body (11) is embodied as a plate.

3. Component according to either of Claims 1 and 2,
- wherein the third electrodes (23) are embodied as dummy electrodes.

4. Component according to any of Claims 1 to 3,
- wherein a first control signal (V₁∼) is applied to the first electrodes (21) and a second control signal (V₂∼) is applied to the second electrodes (22).

5. Component according to any of Claims 1 to 4,
- wherein the polarization axes of the respective piezoelectric layer (P1) in the region of the first and of the second transducer elements (11, 12, C1, C2) are directed in the same direction or in opposite directions.

6. Component arrangement
- comprising at least one piezoelectric component according to any of Claims 1 to 5,
- comprising an oscillatory membrane (4), on which the component is fixed.

7. Component arrangement according to Claim 6,
- wherein a region of the membrane (4) is arranged between two piezoelectric components.

8. Component arrangement according to either of Claims 6 and 7,
- wherein the membrane (4) is suspended from a carrier (6) in at least two regions (71, 72, 73) spaced apart from one another.

## Revendications

1. Composant piézoélectrique présentant un corps (10) dans lequel des éléments de convertisseur (11, 12, C1, C2, C3, C4) reliés électriquement les uns aux autres sont réalisés et sont maintenus à distance les uns des autres par une partie (13) du corps neutre et essentiellement exempte de champ,
un premier élément de convertisseur (11) présentant des premières électrodes (21) reliées mutuellement de manière conductrice et un deuxième élément de convertisseur (12) présentant des deuxièmes électrodes (22) reliées mutuellement de manière conductrice,
au moins une troisième électrode (23) disposée dans le premier et dans le deuxième élément de convertisseur (11, 12) étant prévue,
au moins trois électrodes sélectionnées parmi les premières et les troisièmes électrodes (21, 23) étant disposées en succession alternée et au moins trois électrodes sélectionnées parmi les deuxièmes et les troisièmes électrodes (22, 23) étant disposées en succession alternée,
la zone neutre (13) étant orientée perpendiculairement aux plans dans lesquels les électrodes (21, 22, 23) sont disposées,
le corps (10) présentant des couches piézoélectriques (P1),
**caractérisé en ce que**
l'épaisseur des couches piézoélectriques est plus grande dans une première partie latérale du corps (10) que dans une deuxième partie latérale du corps (10).

2. Composant selon la revendication 1, dans lequel le corps (11) est configuré en plaque.

3. Composant selon l'une des revendications 1 ou 2, dans lequel les troisièmes électrodes (23) sont configurées comme électrodes aveugles.

4. Composant selon l'une des revendications 1 à 3, dans lequel un premier signal de commande (V₁∼) est appliqué sur les premières électrodes (21) et un deuxième signal de commande (V₂∼) est appliqué sur les deuxièmes électrodes (22).

5. Composant selon l'une des revendications 1 à 4, dans lequel les axes de polarisation des différentes couches piézoélectriques (P1) sont orientés dans le même sens ou dans des sens contraires au niveau du premier et du deuxième élément de convertisseur (11, 12, C1, C2).

6. Ensemble de composant présentant au moins un composant piézoélectrique selon l'une des revendications 1 à 5 et une membrane oscillante (4) sur laquelle le composant est fixé.

7. Ensemble de composant selon la revendication 6, dans lequel une partie de la membrane (4) est disposée entre deux composants piézoélectriques.

8. Ensemble de composant selon l'une des revendications 6 ou 7, dans lequel la membrane (4) est suspendue à un support (6) dans au moins deux parties (71, 72, 73) situées à distance l'une de l'autre.
